# EUROPEAN PATENT APPLICATION

(11) **EP 4 404 263 A2**
(43) Date of publication of application: **24.07.2024**
(21) Application number: 24150711.0
(22) Date of filing: 08.01.2024
(51) Int. Cl.: H01L 27/02, H01L 21/8234, H01L 23/528

(54) **INTEGRATED CIRCUIT INCLUDING BACKSIDE WIRING**

(30) Priority: 19.01.2023 KR 20230008269; 18.05.2023 KR 20230064558
(71) Applicant: Samsung Electronics Co., Ltd., Suwon-si, Gyeonggi-do 16677 (KR)
(72) Inventor: DO, Jungho, 16677 Suwon-si, Gyeonggi-do (KR); YU, Jisu, 16677 Suwon-si, Gyeonggi-do (KR); YOU, Hyeongyu, 16677 Suwon-si, Gyeonggi-do (KR); LEE, Seungyoung, 16677 Suwon-si, Gyeonggi-do (KR); JEONG, Minjae, 16677 Suwon-si, Gyeonggi-do (KR)
(74) Representative: Kuhnen & Wacker Patent- und Rechtsanwaltsbüro PartG mbB

(57) **Abstract**

An integrated circuit may include gate electrodes including first and second gate electrodes being apart in a first direction and third and fourth gate electrodes being apart in the first direction. The second and third gate electrodes receive a first control signal, and the first and fourth gate electrodes receive a second control signal. The integrated circuit further includes a first drain region between the first and second gate electrodes and a second drain region between the third and fourth gate electrodes, wherein the first and second drain regions are electrically connected to each other. The integrated circuit includes a front-side wiring layer connected to at least one of the first and second drain regions and the first to fourth gate electrodes, and a backside wiring layer connected to at least another one of the first and second drain regions and the first to fourth gate electrodes.

## Description

### BACKGROUND

Apparatuses and methods associated with example embodiments of the present disclosure relate to an integrated circuit, and more particularly, to an integrated circuit including a backside wiring and a method of designing the same.

Due to the need for high degree of integration and the development of semiconductor processing, the width of, distance between, and/or height of wirings included in an integrated circuit may be reduced, and an effect of a parasitic element of a wiring may be increased. In addition, a power supply voltage of an integrated circuit may be decreased for reduced power consumption and high operation speed, and thus, the effect of the parasitic element of the wiring on the integrated circuit may be increased even more. Accordingly, the need for an integrated circuit capable of efficiently routing wirings and vias have been increased.

### SUMMARY

One or more example embodiments provide an integrated circuit of which the routing complexity may be reduced by using a front-side wiring layer and a backside wiring layer, and the performance may be improved by transmitting a voltage by using the both the front-side wiring layer and the backside wiring layer, and a method of designing the integrated circuit.

According to an aspect of the present disclosure, an integrated circuit may include: a plurality of gate electrodes including a first gate electrode and a second gate electrode being apart in a first direction, and a third gate electrode and a fourth gate electrode being apart in the first direction, wherein the second gate electrode and the third gate electrode are configured to receive a first control signal, and the first gate electrode and the fourth gate electrode are configured receive a second control signal; a plurality of drain regions including a first drain region between the first gate electrode and the second gate electrode, and a second drain region between the third gate electrode and the fourth gate electrode, wherein the first drain region and the second drain region are configured to be electrically connected to each other; a front-side wiring layer disposed above the plurality of gate electrodes in a vertical direction and connected to at least one of the plurality of drain regions and the plurality of gate electrodes; and a backside wiring layer disposed under the plurality of gate electrodes in the vertical direction and connected to at least another one of the plurality of drain regions and the plurality of gate electrodes.

According to another aspect of the present disclosure, an integrated circuit may include: a source region and a drain region being apart in a first direction; a first gate electrode extending in a second direction perpendicular to the first direction, between the source region and the drain region; first backside contacts disposed under the source region and the drain region in a vertical direction and respectively connected to the source region and the drain region; and a backside wiring layer connected to the first backside contacts, wherein the source region and the drain region are configured to receive a same voltage from the backside wiring layer through the first backside contacts.

According to another aspect of the present disclosure, an integrated circuit may include: a source region and a drain region being apart in a first direction; a first gate electrode extending in a second direction perpendicular to the first direction, between the source region and the drain region; a first backside contact disposed under the source region or the drain region in a vertical direction to be connected to the source region or the drain region and configured to receive a first voltage; and a second backside contact disposed under the first gate electrode in the vertical direction to be connected to the first gate electrode and configured to receive the first voltage.

According to another aspect of the present disclosure, an integrated circuit may include: a first gate electrode and a second gate electrode being apart in a first direction and extending in a second direction perpendicular to the first direction; a source or drain region between the first gate electrode and the second gate electrode; a first contact connected to the source or drain region; a second contact connected to the first gate electrode; a front-side wiring layer disposed above the first gate electrode and the second gate electrode in a vertical direction; and a backside wiring layer disposed under the first gate electrode and the second gate electrode in the vertical direction, the backside wiring layer being connected to at least one of the first contact and the second contact.

According to another aspect of the present disclosure, an integrated circuit may include: a first cell and a second cell provided in a first direction; a front-side wiring layer disposed above the first cell and the second cell, the front-side wiring layer including a first front-side wiring pattern and a second front-side wiring pattern each extending in the first direction and being apart in a second direction perpendicular to the first direction; and a backside wiring layer disposed under the first cell and the second cell, the backside wiring layer including a first backside wiring pattern extending in the first direction. The first cell may include: a first gate electrode and a second gate electrode each extending in the second direction; a first source or drain region between the first gate electrode and the second gate electrode; a first contact between the first source or drain region and the first backside wiring pattern; and a second contact between the first gate electrode and the first front-side wiring pattern. The second cell may include: a third gate electrode and a fourth gate electrode each extending in the second direction; a second source or drain region between the third gate electrode and the fourth gate electrode; a third contact between the second source or drain region and the first backside wiring pattern; and a fourth contact between the third gate electrode and the second front-side wiring pattern.

### BRIEF DESCRIPTION OF THE DRAWINGS

Embodiments will be more clearly understood from the following detailed description taken in conjunction with the accompanying drawings in which:
FIG. 1 shows a layout of an integrated circuit according to an embodiment;
FIG. 2 is a circuit diagram showing a cross-coupled structure according to an embodiment;
FIG. 3A is a plan view showing the front-side of the integrated circuit of FIG. 1, according to an embodiment, and FIG. 3B is a plan view showing the backside of the integrated circuit of FIG. 1, according to an embodiment;
FIG. 4A is a cross-sectional view of the integrated circuit taken along line X1aX1a' of FIG. 1, according to an embodiment, and FIG. 4B is a cross-sectional view of the integrated circuit taken along line X1b-X1b' of FIG. 1, according to an embodiment;
FIG. 5 shows a layout of an integrated circuit according to an embodiment;
FIG. 6A is a plan view showing the front-side of the integrated circuit of FIG. 5, according to an embodiment, and FIG. 6B is a plan view showing the backside of the integrated circuit of FIG. 5, according to an embodiment;
FIG. 7A is a cross-sectional view of the integrated circuit taken along line X2aX2a' of FIG. 5, according to an embodiment, and FIG. 7B is a cross-sectional view of the integrated circuit taken along line X2b-X2b' of FIG. 5, according to an embodiment;
FIG. 8 shows a layout of an integrated circuit according to an embodiment;
FIG. 9A is a plan view showing the front-side of the integrated circuit of FIG. 8, according to an embodiment, and FIG. 9B is a plan view showing the backside of the integrated circuit of FIG. 8, according to an embodiment;
FIG. 10A is a cross-sectional view of the integrated circuit taken along line L3a-L3a' of FIG. 8, according to an embodiment, and FIG. 10B is a cross-sectional view of the integrated circuit taken along line L3b-L3b' of FIG. 8, according to an embodiment;
FIG. 11 shows a layout of an integrated circuit according to an embodiment;
FIG. 12A is a cross-sectional view of the integrated circuit taken along line X4aX4a' of FIG. 11, according to an embodiment, and FIG. 12B is a cross-sectional view of the integrated circuit taken along line X4b-X4b' of FIG. 11, according to an embodiment;
FIG. 13 shows a layout of an integrated circuit according to an embodiment;
FIG. 14A is a cross-sectional view of the integrated circuit taken along line X5aX5a' of FIG. 13, according to an embodiment, and FIG. 14B is a cross-sectional view of the integrated circuit taken along line X5b-X5b' of FIG. 13, according to an embodiment;
FIG. 15 shows a layout of an integrated circuit according to an embodiment;
FIG. 16A is a cross-sectional view of the integrated circuit taken along line X6aX6a' of FIG. 15, according to an embodiment, and FIG. 16B is a cross-sectional view of the integrated circuit taken along line X6b-X6b' of FIG. 15, according to an embodiment;
FIG. 17 shows a layout of an integrated circuit according to an embodiment;
FIG. 18 is a cross-sectional view of the integrated circuit taken along line X7-X7' of FIG. 17, according to an embodiment;
FIG. 19 shows a layout of an integrated circuit according to an embodiment;
FIG. 20A is a cross-sectional view of the integrated circuit taken along line X8-X8' of FIG. 19, according to an embodiment, and FIG. 20B is a cross-sectional view of the integrated circuit taken along line X8-X8' of FIG. 19, according to an embodiment;
FIG. 21 shows a layout of an integrated circuit according to an embodiment;
FIG. 22 is a cross-sectional view of the integrated circuit taken along line X9-X9' of FIG. 21, according to an embodiment;
FIG. 23 shows a layout of an integrated circuit according to an embodiment;
FIGS. 24 to 28 each show a layout of an integrated circuit according to some embodiments;
FIGS. 29A to 29D each show a device according to some embodiments;
FIG. 30 is a flowchart of a method for manufacturing an integrated circuit, according to an embodiment;
FIG. 31 is a block diagram of a system-on-chip according to an embodiment; and
FIG. 32 is a block diagram showing a computing system including a memory storing a program, according to an embodiment.

### DETAILED DESCRIPTION OF THE EMBODIMENTS

Hereinafter, embodiments of the inventive concept will be described in detail with reference to the accompanying drawings. Same reference numerals are used for same components in the drawings, and repeated description thereof will be omitted.

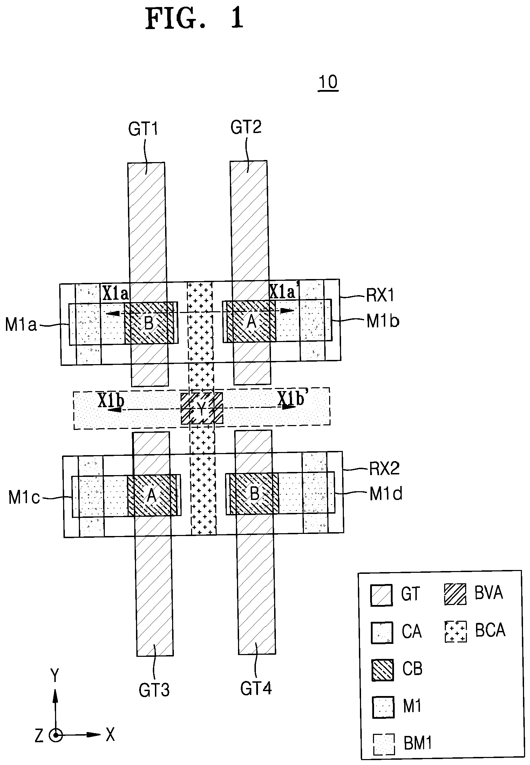

FIG. 1 shows a layout of an integrated circuit 10 according to an embodiment.

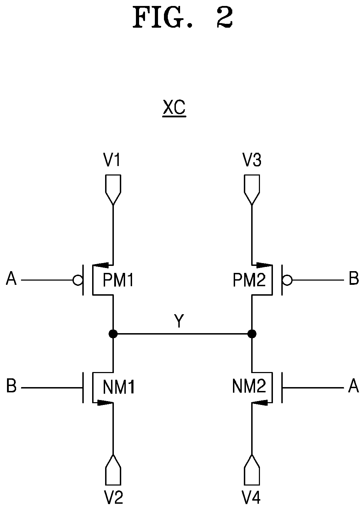

Referring to FIG. 1, the integrated circuit 10 may include first and second active regions RX1 and RX2, gate electrodes GT, first contacts CA, second contacts CB, a front-side wiring layer M1, a backside wiring layer BM1, a backside viaBVA, and a first backside contact BCA. In some embodiments, the backside wiring layer BM1 may be referred as a "rear wiring layer", the backside via BVA may be referred as a "rear via", and the first backside contact BCA may be referred as a "first rear contact." In an embodiment, the first and second active regions RX1 and RX2, the gate electrodes GT, the first contacts CA, the second contacts CB, the front-side wiring layer M1, the backside wiring layer BM1, the backside via BVA, and the first backside contact BCA may constitute a standard cell. In FIG. 1, only a partial representation of the standard cell within the integrated circuit 10 is illustrated for convenience of explanation, and the standard cell may be designed to incorporate additional components as needed. According to an embodiment, the integrated circuit 10 may be referred to as an "integrated circuit device" or a "semiconductor device". For example, the integrated circuit 10 may correspond to a cross-coupled structure XC of FIG. 2.

The integrated circuit 10 may include a plurality of standard cells. The standard cell method involves preparing standard cells with various functions in advance and subsequently combining the standard cells to design an exclusive large-scale integrated circuit that meets the specifications of customers or users. A standard cell may be a fundamental building block or a basic unit used to create complex digital electronic circuits or specific logical functions. The standard cell is designed and verified in advance to be registered in a standard cell library, and the integrated circuit 10 may be designed by using a computer aided design (CAD) tool for logical design, placement, and routing. During the design process of the integrated circuit 10, the performance of the integrated circuit 10 may further be improved by reducing the length and routing complexity of the wirings and/or vias.

According to the present embodiment, the integrated circuit 10 may include the front-side wiring layer M1 and the backside wiring layer BM1 to establish a power distribution network (PDN). This configuration effectively divides the signals and power transmission duties for the source/drain regions of the first and second active regions RX1 and RX2 and/or the gate electrodes GT. Some signals and powers are transmitted through the front-side wiring layer M1, while the remainder is delivered through the backside wiring layer BM1. Therefore, according to the present embodiment, the performance of the integrated circuit 10 may be improved because the routing complexity may be greatly reduced compared to the structure in which the wirings are located only on the front-side of the substrate, and the length of each wiring or via may be reduced. In the present disclosure, the term "source/drain region" may refer to a source region alone, a drain region alone, or both the source region and the drain region.

FIG. 2 is a circuit diagram illustrating a cross-coupled structure XC according to an embodiment.

Referring to FIG. 2, the cross-coupled structure XC may include a first p-channel metal-oxide semiconductor (PMOS) transistor PM1 and a first n-channel metal-oxide semiconductor (NMOS) transistor NM1 connected in series with each other, and a second PMOS transistor PM2 and a second NMOS transistor NM2 connected in series with each other. The cross-coupled structure XC according to the present embodiment may be included in various standard cells, for example, sequential cells such as a latch and a flip-flop, or combinational cells such as a multiplexer or an adder.

In detail, the first PMOS transistor PM1 may include a source connected to a first voltage terminal V1, a gate that receives a first control signal A, and a drain connected to an output node Y. The first NMOS transistor NM1 may include a drain connected to the output node Y, a gate that receives a second control signal B, and a source connected to a second voltage terminal V2. The second PMOS transistor PM2 may include a source connected to a third voltage terminal V3, a gate that receives a second control signal B, and a drain connected to the output node Y. The second NMOS transistor NM2 may include a drain connected to the output node Y, a gate that receives the first control signal A, and a source connected to a fourth voltage terminal V4. For example, the first and third voltage terminals V1 and V3 may receive a positive supply voltage, for example, a power supply voltage VDD, and the second and fourth voltage terminals V2 and V4 may receive a negative power supply voltage, for example, a ground voltage VSS, but embodiments are not limited thereto.

In the present embodiment, the gates of the first PMOS transistor PM1 and the second NMOS transistor NM2 may be electrically interconnected to receive the first control signal A. In addition, the gates of the first NMOS transistor NM1 and the second PMOS transistor PM2 may be electrically interconnected to receive the second control signal B. Accordingly, the arrangement of the first and second PMOS transistors PM1 and PM2, along with the first and second NMOS transistors NM1 and NM2, may constitute the cross-coupled structure XC. According to the embodiments, some of the wirings that transmit the first and second control signals A and B and the wirings corresponding to the output node Y may be implemented as, for example, front-side wiring layers including the front-side wiring layer M1 of FIG. 1, while others may be implemented using backside wiring layers, including the backside wiring layer BM1 as illustrated in FIG. 1.

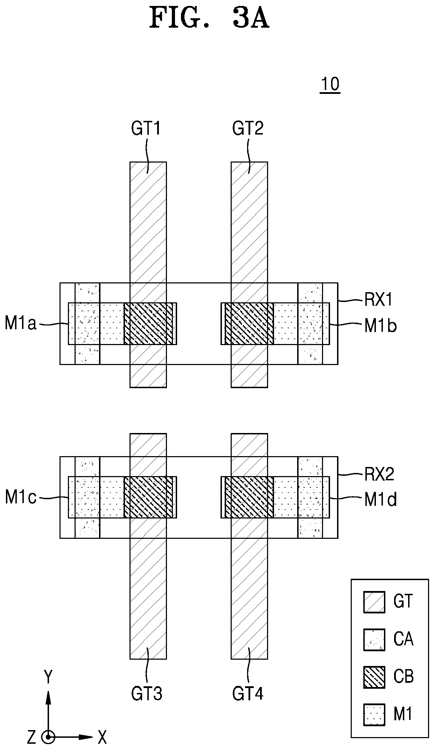

FIG. 3A is a plan view showing the front-side of the integrated circuit 10 of FIG. 1 according to an embodiment.

Referring to FIGS. 1 and 3A, the integrated circuit 10 may be implemented as a semiconductor device, and a substrate on which the semiconductor device is formed may have two opposing surfaces, first and second surfaces. The first surface may be, for example, a side accommodating circuit elements such as a transistor, and may be referred to as the "front-side" in the specification. The second surface may be a side facing the first surface and may be referred to as the "backside" in the specification.

In the front-side of the substrate, the first and second active regions RX1 and RX2 may each extend in a first direction X, and may be apart from each other in a second direction Y. In this case, the first direction X may be referred to as a first horizontal direction, the second direction Y may be referred to as a second horizontal direction, and the first direction X and the second direction Y may be perpendicular to each other. A plane consisting of the first direction X and the second direction Y may be referred to as a horizontal surface. For example, the first and second active regions RX1 and RX2 may have different conductive types. The first and second active regions RX1 and RX2 may be referred to as "diffusion regions." The diffusion region, which is a region on which impurities that change the electrical properties of the substrate material are doped, may form the source/drain region of a transistor. In an embodiment, an area between the first and second active regions RX1 and RX2 may be referred to as a dummy region.

The gate electrodes GT may include first to fourth gate electrodes GT1 to GT4 each extending in the second direction Y. The gate electrodes GT may be defined as a conductive segment including a conductive material such as polysilicon and at least one metal. The first and second gate electrodes GT1 and GT2 may be apart from each other in the first direction X and may cross the first active region RX1. The third and fourth gate electrodes GT3 and GT4 may be apart from each other in the first direction X and may cross the second active region RX2. The first and third gate electrodes GT1 and GT3 may be disposed in a line along the second direction Y, and the second and fourth gate electrodes GT2 and GT4 may be disposed in a line along the second direction Y. For example, by applying a cutting layer to the two gate lines spaced in the first direction X, the first to fourth gate electrodes GT1, GT2, GT3, and GT4 may be generated.

The first contacts CA may be respectively disposed on the source/drain regions of the first active region RX1 and the source/drain regions of the second active region RX2. In this regard, the first contacts CA may be respectively arranged on the source/drain regions and be respectively connected to the source/drain regions, and thus may be referred to as the "source/drain contact." According to an embodiment, the first contacts CA may be referred to as the source/drain contact patterns or the source/drain contact plugs. In this regard, the source/drain region may include an epitaxial region of a semiconductor material such as silicon, boron, phosphorus, germanium, carbon, SiGe, and/or SiC.

The second contacts CB may be respectively disposed on the first to fourth gate electrodes GT1 to GT4. In this regard, the second contacts CB may be respectively arranged on the gate electrodes and be respectively connected to the gate electrodes, and thus may be referred to as a "gate contact." According to an embodiment, the second contacts CB may be referred to as the gate contact patterns or the gate contact plugs.

The front-side wiring layer M1 may include a plurality of conductive patterns or plurality of patterns including conductive materials. Herein, "patterns" may refer to conductive patterns. For example, the front-side wiring layer M1 may include front-side wiring patterns M1a to M1d each extending in the first direction X. In this case, the pattern extending in one direction may be referred to as a "line", and accordingly, the front-side wiring patterns M1a to M1d may be referred to as front-side wiring lines. The first to fourth gate electrodes GT1 to GT4 may be connected to the front-side wiring patterns M1a to M1d, respectively, through the second contacts CB. The second and third gate electrodes GT2 and GT3 may receive the first control signal A through the second contacts CB. The first and fourth gate electrodes GT1 and GT4 may receive a second control signal B through the second contacts CB .

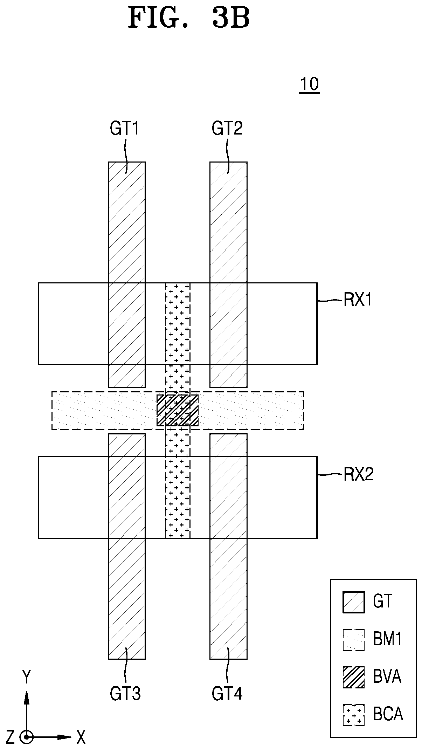

FIG. 3B is a plan view showing the backside of the integrated circuit 10 of FIG. 1, according to an embodiment.

Referring to FIGS. 1 and 3B, the first and second active regions RX1 and RX2 and the first to fourth gate electrodes GT1 to GT4 are illustrated to describe the position of the components disposed on the backside of the integrated circuit 10. In general, the first and second active regions RX1 and RX2 may be seen on the front side of the integrated circuit 10, but may also be seen on the backside of the integrated circuit 10 depending on the thickness of the substrate. For example, in the case of a semiconductor device implemented with a thin silicon substrate, the first and second active regions RX1 and RX2 may also extend to the backside of the integrated circuit 10.

The first backside contact BCA may extend between the first and second gate electrodes GT1 and GT2 and between the third and fourth gate electrodes GT3 and GT4 in the second direction Y. The first backside contact BCA may connect layers and elements on the backside to elements in the substrate, for example, the diffusion regions. Specifically, the first backside contact BCA may be connected to the source/drain region of the first active region RX1 and the source/drain region of the second active region RX2. Accordingly, the first backside contact BCA may be referred to as "backside source/drain contact." In this regard, a contact connected to the lower portion of an epitaxial region such as the source/drain region may be referred to as a "direct backside contact (DBC)." In an embodiment, the DBC may include a backside contact and/or a backside via.

The integrated circuit 10 may include a first drain region between the first and second gate electrodes GT1 and GT2 and a second drain region between the third and fourth gate electrodes GT3 and GT4, and the first and second drain regions may be electrically connected to each other through the first backside contact BCA. For example, the first and second drain regions may correspond to the output node (e.g., the output node Y) of FIG. 2.

The backside wiring layer BM1 may be disposed on the backside of the substrate and may be connected to the first backside contact BCA through the backside via BVA. The backside via BVA may connect layers and elements on the backside to elements in the substrate, for example, the diffusion regions. The backside wiring layer BM1 may extend in the first direction X between the first and second active regions RX1 and RX2, but the disclosure is not limited thereto. In some embodiments, the backside wiring layer BM1 may extend in the second direction Y. In some embodiments, the backside wiring layer BM1 may partially overlap the first active region RX1 and/or second active region RX2. In this regard, the arrangement and/or extension direction of the backside wiring layer BM1 may be variously modified according to an embodiment.

The semiconductor device corresponding to the integrated circuit 10 may receive power through a power distribution network including conductive materials such as wirings and vias. According to the inventive concept, by providing the power distribution network by using the wiring layers disposed on the front and/or the backside of the substrate, the routing complexity may be reduced and the performance of the semiconductor device may be improved. In particular, when the cross-coupled structure is implemented by using only the front-side wiring layer, the distance between the wirings is short, and accordingly, the routing complexity is very high. However, according to the present embodiment, by applying gate voltages by using the front-side wiring layer M1 and implementing the output node by using the backside wiring layer BM1, the distance between the wirings may be increased compared to the conventional wirings, and thus, the routing complexity for the integrated circuit 10 may be reduced.

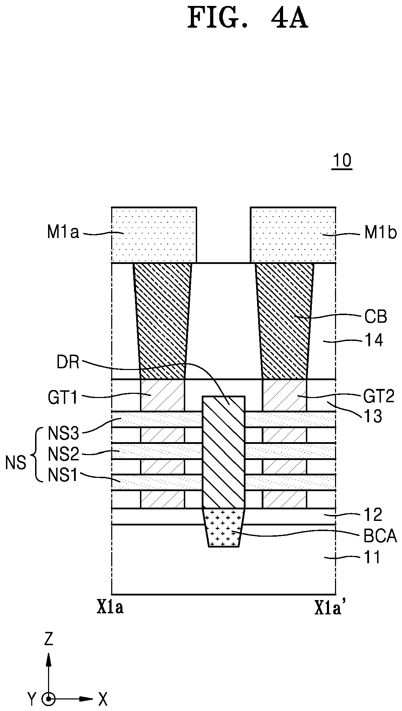

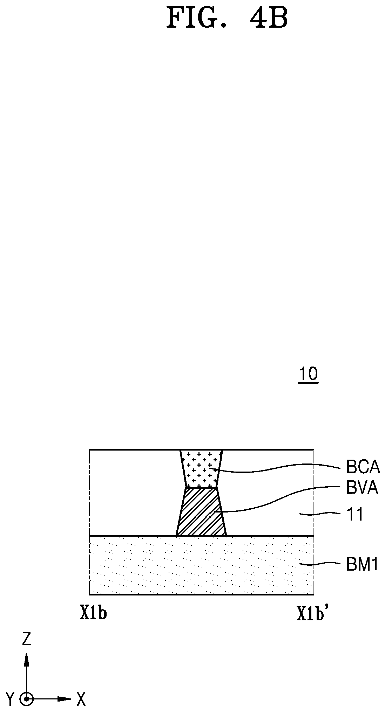

FIG. 4A is a cross-sectional view of the integrated circuit taken along line X1aX1a' of FIG. 1, according to an embodiment, and FIG. 4B is a cross-sectional view of the integrated circuit taken along line X1b-X1b' of FIG. 1, according to an embodiment.

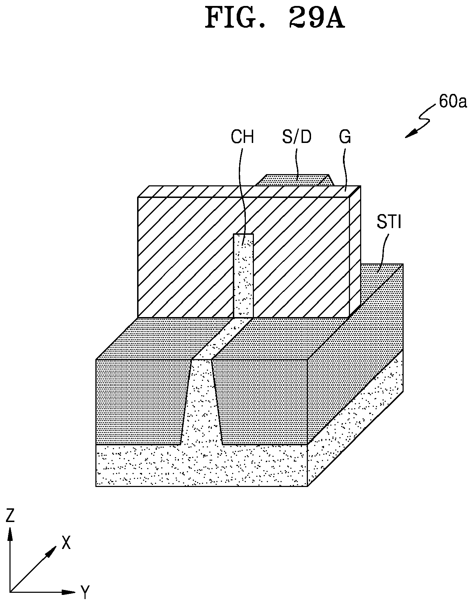

FIGS. 4A and 4B each show an example in which a nanosheet is formed in the active region. For example, a multi-bridge channel (MBC) field-effect transistor (FET) in which a plurality of nanosheets are stacked on the active region and the gate electrode surrounding the plurality of nanosheets may be formed. However, the integrated circuit according to the inventive concept is not limited to those shown in FIGS. 4A and 4B. For example, a FinFET, including a fin formed on the active region and the gate electrode, may be formed, or, for example, a gate-all-around (GAA) FET in which a nanowire, formed on the active region, is surrounded by the gate electrode may be formed. A vertical GAA FET in which a plurality of nanowires are vertically stacked on the active region and surrounded by the gate electrode may be formed. In addition, for example, a negative capacitance (NC) FET may be formed on the active region. Furthermore, in addition to the above examples, various transistors (complementary FET (CFET), NCFET, carbon nanotube FET (CNT), a bipolar junction transistor, etc.) may be formed on the active region. In this regard, description will be made with reference to FIGS. 29A to 29D.

Referring to FIGS. 1, 4A and 4B, in an embodiment, a first layer 11 may include a substrate or a semiconductor substrate. For example, the semiconductor substrate may include any one of silicon, silicon-on-insulator (SOI), silicon-on-sapphire, germanium, silicongermanium, and gallium-arsenide. However, the inventive concept is not limited thereto, and in an embodiment, the first layer 11 may include an insulating layer. For example, during a manufacturing process of the integrated circuit 10, a device wafer may be formed by forming gate electrodes, source/drain regions, contacts, vias, and/or wiring layers on the front-side of the substrate. Subsequently, the device wafer may be temporarily bonded to the carrier wafer and a back-grinding process for the device wafer may be performed. At least a portion of the substrate may be removed by the back-grinding process, and the insulating layer may be formed where at least a portion of the substrate is removed. In this regard, the wafers that are backgrinded such that the height of the substrate is equal to or less than a standard or predetermined height may be referred to as a "bulkless wafer" or a "bulkless substrate."

The first layer 11 or the upper region of the first layer 11 of FIG. 4A may correspond to the first active region RX1. For example, the first active region RX1 may be formed in an N well formed in a P-type substrate, and P-type transistors may be disposed in the first active region RX1. For example, the second active region RX2 may be formed in a P-type substrate, and N-type transistors may be disposed in the second active region RX2. An element isolation layer such as the shallow trench isolation (STI), may be disposed between the first active region RX1 and the second active region RX2. The first active region RX1 and the second active region RX2 may be separated by the element isolation layer, and the first layer11 or the upper region of the first layer 11 of FIG. 4B may correspond to the element isolation layer.

A first interlayer insulating layer 12, a second interlayer insulating layer 13, and a third interlayer insulating layer 14 may be sequentially stacked on the first layer 11 in a vertical direction Z with respect to the first layer 11. The first to third interlayer insulating layers 12, 13, and 14 may include an insulating material. For example, the insulating material may include any one of an oxide film, a nitride film, or an oxynitride film. In the present specification, a component disposed relatively to the vertical direction Z, that is, the Z axis direction, more than another component, may be referred to as being on or in the upper part of the other component, and a component disposed relatively to a reverse direction of the vertical direction Z, that is, the -Z axis direction, more than another component, may be referred to as being under or in the lower part of the other component.

A nanosheet stack NS extending in the first direction X may be disposed above the first active region RX1. The nanosheet stack NS may include a plurality of nanosheets overlapping in the vertical direction Z, for example, first to third nanosheets NS1 to NS3. For example, the nanosheet stack NS disposed on the first active region RX1 may be doped with N-type impurities and may form a P-type transistor. On the other hand, the nanosheet stack NS disposed on the second active region RX2 may be doped with P-type impurities and may form an N-type transistor. In an embodiment, the nanosheet stack NS may include Si, Ge, or SiGe. In an embodiment, the nanosheet stack NS may include InGaAs, InAs, GaSb, InSb, or a combination thereof.

The first and second gate electrodes GT1 and GT2 may respectively surround the first to third nanosheets NS1 to NS3 while covering the nanosheet stack NS. As a result, the first to third nanosheets NS1 to NS3 may have a GAA structure. A gate insulating layer may be interposed between the first and second gate electrodes GT1 and GT2 and between the first to third nanosheets NS1 to NS3. The second contacts CB may be respectively disposed on the first and second gate electrodes GT1 and GT2, and the front-side wiring patterns M1a and M1b may be disposed on the second contacts CB. The first and second gate electrodes GT1 and GT2 may include, for example, metal materials such as tungsten (W), tantalum (Ta), etc., a nitride thereof, a silicide thereof, a doped polysilicon, etc., and may be formed by, for example, a deposition process. The second contacts CB may include any material having electrical conductivity such as W.

The drain region DR may be disposed between the first and second gate electrodes GT1 and GT2. For example, the drain region DR may include an epitaxial region of a semiconductor material, and may have a different type of doping material from the doping material of the first active region RX1. In this case, the drain region DR may correspond to the output node (e.g., the output node Y). The first backside contact BCA may be disposed under the drain region DR and be connected to the drain region DR. The first backside contact BCA may extend in the second direction Y, and thus, may be connected to the drain regions of the first and second active regions RX1 and RX2, that is, the output node (e.g., the output node Y). The backside via BVA may be disposed on the element isolation layer between the first and second active regions RX1 and RX2. Accordingly, the drain region DR may be electrically connected to the backside wiring layer BM1 through the first backside contact BCA and the backside via BVA.

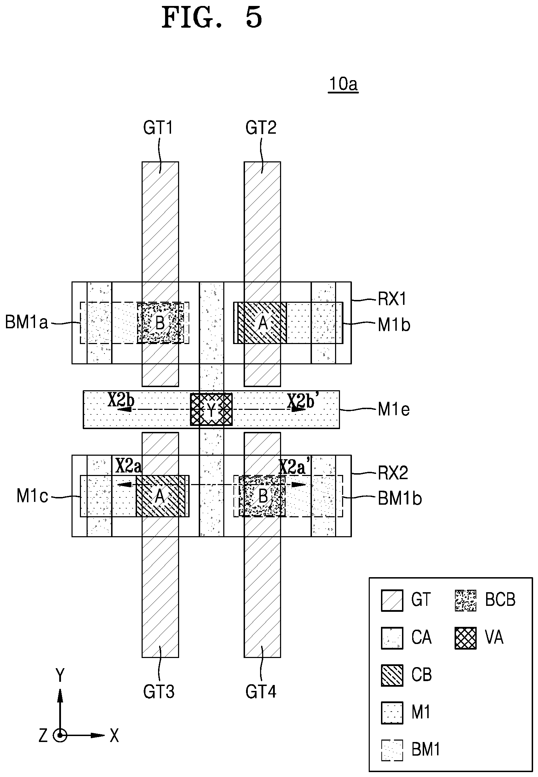

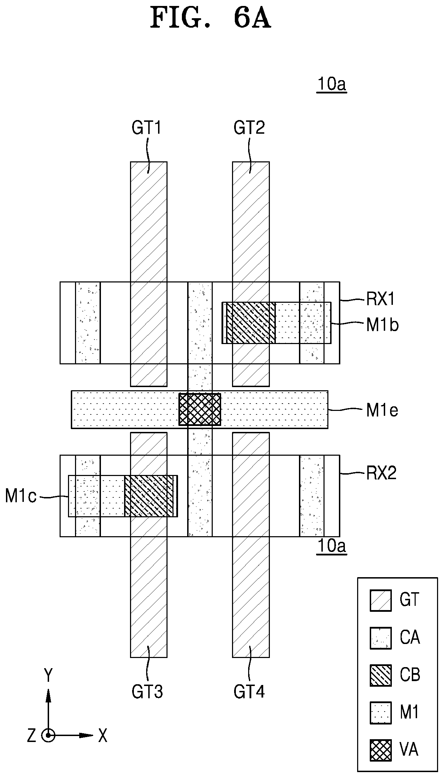

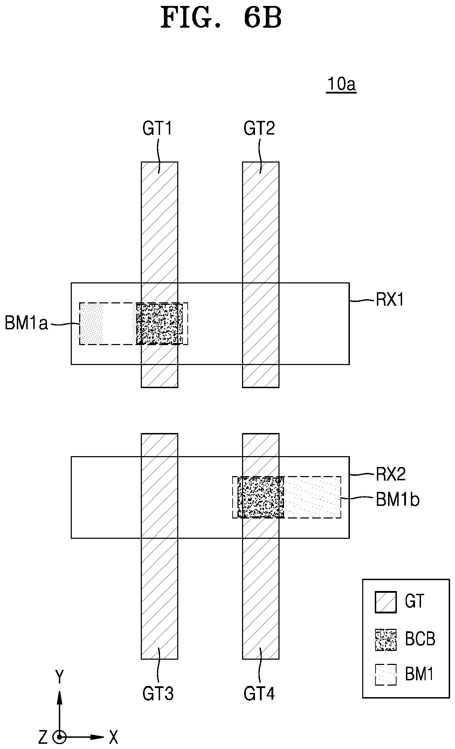

FIG. 5 shows a layout of an integrated circuit 10a according to an embodiment. FIG. 6A is a plan view showing the front-side of the integrated circuit 10a of FIG. 5, according to an embodiment, and FIG. 6B is a plan view showing the backside of the integrated circuit 10a of FIG. 5, according to an embodiment.

Referring to FIGS. 5 to 6B, the integrated circuit 10a corresponds to a modified example of the integrated circuit 10 of FIG. 1, and the descriptions made with reference to FIGS. 1 to 4B may apply to the present embodiment. The integrated circuit 10a may include the first and second active regions RX1 and RX2, the first to fourth gate electrodes GT1 to GT4, the first contacts CA, the second contacts CB, the via VA, the front-side wiring layer M1, the backside wiring layer BM1, and the second backside contacts BCB. The front-side wiring layer M1 may include the front-side wiring patterns M1b, M1c, and M1e each extending in the first direction X. The backside wiring layer BM1 may include the backside wiring patterns BM1a and BM1b each extending in the first direction X.

The first contacts CA may be respectively disposed on the source/drain regions of the first active region RX1 and the source/drain regions of the second active region RX2. The first contact CA extending in the second direction Y between the first and second gate electrodes GT1 and GT2 may be connected to the front-side wiring pattern M1e through the via VA. The second contacts CB may be respectively disposed on the second and third gate electrodes GT2 and GT3. The second and third gate electrodes GT2 and GT3 may be connected to the front-side wiring patterns M1b and M1c, respectively, through the second contacts CB, and may receive the first control signal A from the front-side wiring patterns M1b and M1c, respectively.

The second backside contacts BCB may be respectively disposed on the first and fourth gate electrodes GT1 and GT4. Accordingly, the second backside contacts BCB may be referred to as "backside gate contacts." The backside wiring layer BM1 may be disposed on the backside of the substrate and may be connected to the first and fourth gate electrodes GT1 and GT4 through the second backside contacts BCB. The first and fourth gate electrodes GT1 and GT4 may be connected to the backside wiring patterns BM1a and BM1b, respectively, through the second backside contacts BCB, and may receive the second control signal B from the backside wiring patterns BM1a and BM1b. In an embodiment, the backside wiring patterns BM1a and BM1b may extend in the first direction X under the first and second active regions RX1 and RX2, but the inventive concept is not limited thereto. In some embodiments, the backside wiring patterns BM1a and BM1b may extend in the second direction Y.

According to the present embodiment, a voltage, for example, the first control signal A may be applied to some of the gate electrodes (e.g., the second and third gate electrodes GT2 and GT3) by using the front-side wiring layer M1, a voltage, for example, the second control signal B may be applied to the other gate electrodes (e.g., the first and fourth gate electrodes GT1 and GT4) by using the backside wiring layer BM1, and the output node may be implemented by using the front-side wiring layer M1 Thus, the distance between the wirings may be increased compared to the conventional wirings, and accordingly, the routing complexity for the integrated circuit 10a may be reduced.

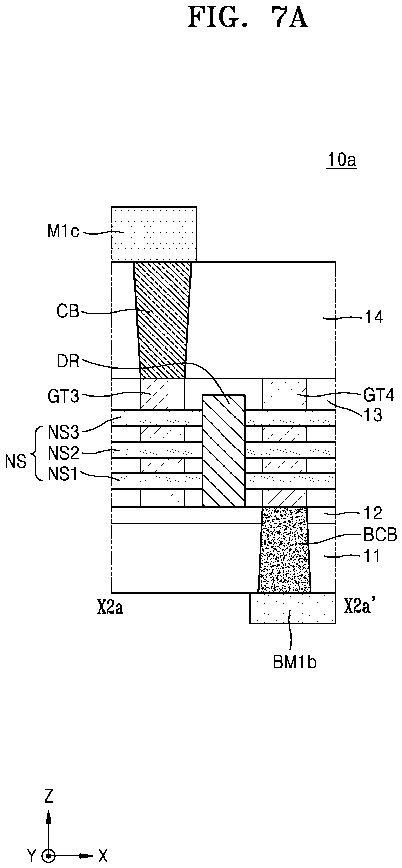

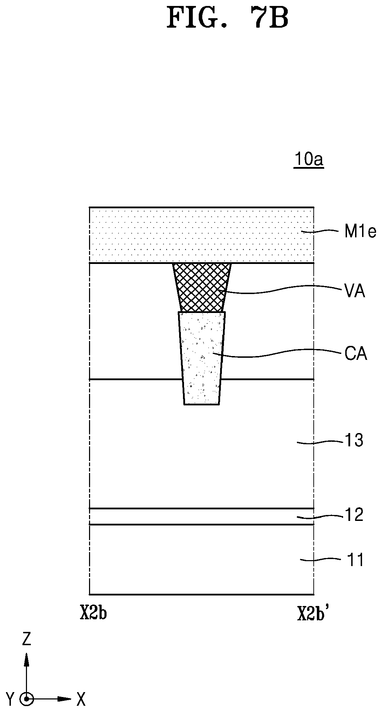

FIG. 7A is a cross-sectional view of the integrated circuit taken along line X2aX2a' of FIG. 5, according to an embodiment, and FIG. 7B is a cross-sectional view of the integrated circuit taken along line X2b-X2b' of FIG. 5, according to an embodiment The description made above with reference to FIGS. 4A and 4B may also be applied to the present embodiment.

Referring to FIGS. 5, 7A, and 7B, the first layer 11 or the upper region of the first layer 11 of FIG. 7A may correspond to the second active region RX2, and the first layer 11 or the upper region of the first layer 11 of FIG. 7B may correspond to the element isolation layer. The third and fourth gate electrodes GT3 and GT4 may respectively surround the first to third nanosheets NS 1 to NS3 while covering the nanosheet stack NS. The drain region DR may be disposed between the third and fourth gate electrodes GT3 and GT4.

The second contact CB may be disposed on the third gate electrode GT3, and the front-side wiring pattern M1c may be disposed on the second contact CB. As a result, the third gate electrode GT3 may receive a first control signal A from the front-side wiring pattern M1C. The second backside contact BCB may be connected to the fourth gate electrode GT4, and the fourth gate electrode GT4 may be electrically connected to the backside wiring pattern BM1b through the second backside contact BCB. As a result, the fourth gate electrode GT4 may receive a second control signal B from the backside wiring pattern BM1b. In an embodiment, the backside via may be further disposed between the second backside contact BCB and the backside wiring pattern BM1b.

In a dummy region between the first and second active regions RX1 and RX2, the via VA may be disposed on the first contact CA, and the front-side wiring pattern M1e may be disposed on the via VA. The first contact CA extends in the second direction Y, and accordingly, the drain region DR may be electrically connected to the front-side wiring pattern M1e through the first contact CA and the via VA.

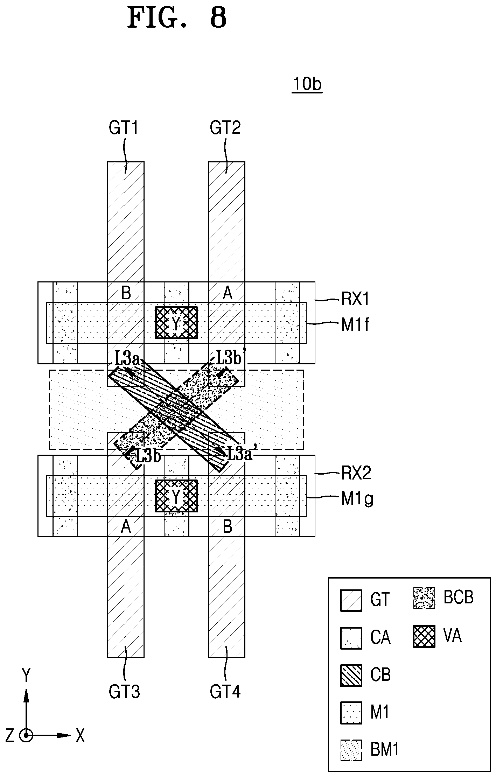

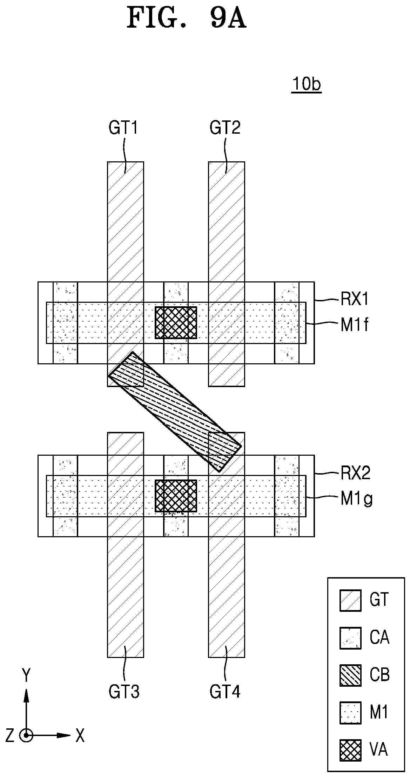

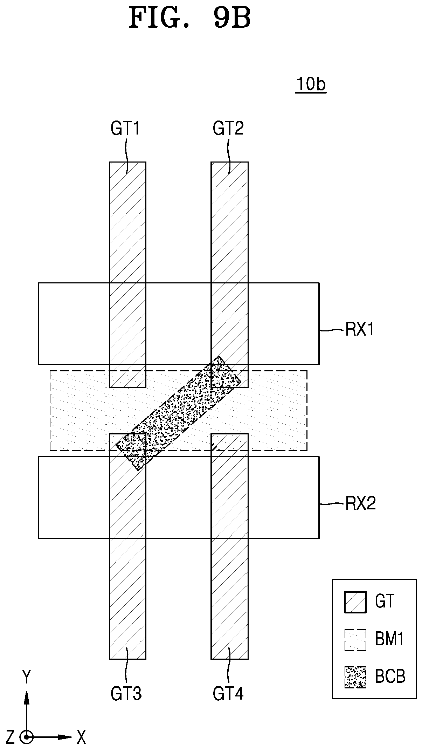

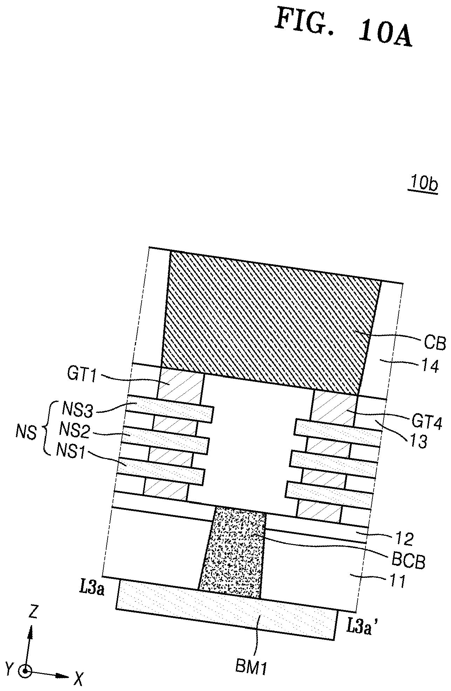

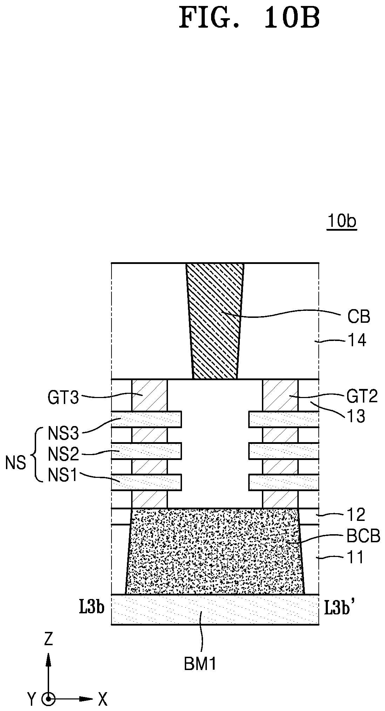

FIG. 8 shows a layout of an integrated circuit 10b according to an embodiment. FIG. 9A is a plan view showing the front-side of the integrated circuit 10b of FIG. 8, according to an embodiment, and FIG. 9B is a plan view showing the backside of the integrated circuit 10b of FIG. 8, according to an embodiment. FIG. 10A is a cross-sectional view of the integrated circuit taken along line L3a-L3a' of FIG. 8, according to an embodiment, and FIG. 10B is a cross-sectional view of the integrated circuit taken along line L3b-L3b' of FIG. 8, according to an embodiment.

Referring to FIGS. 8 to 10B, the integrated circuit 10b corresponds to a modified example of the integrated circuit 10 of FIG. 1, and the descriptions made with reference to FIGS. 1 to 4B may apply to the present embodiment. The integrated circuit 10b may include the first and second active regions RX1 and RX2, the first to fourth gate electrodes GT1 to GT4, the first contacts CA, the second contact CB, the via VA, the front-side wiring layer M1, the backside wiring layer BM1, and the second backside contact BCB. For example, the front-side wiring layer M1 may include front-side wiring patterns M1f and M1g each extending in the first direction X.

The first contacts CA may be respectively disposed on the source/drain regions of the first active region RX1 and the source/drain regions of the second active region RX2. In an embodiment, the vias VA may respectively be disposed on the first contacts CA disposed in the first drain region between the first and second gate electrodes GT1 and GT2 and the second drain region between the third and fourth gate electrodes GT3 and GT4, and the front-side wiring patterns M1f and M1g may respectively be disposed on the vias VA. Accordingly, the first and second drain regions may be electrically connected to the front-side wiring patterns M1f and M1g. However, the inventive concept is not limited thereto, and, in some embodiments, backside vias and/or backside contacts may respectively be disposed in the first drain region between the first and second gate electrodes GT1 and GT2 and the second drain region between the third and fourth gate electrodes GT3 and GT4, and the backside wiring layer BM1 may be disposed under the backside vias and the backside contacts. Accordingly, the first and second drain regions may be electrically connected to the backside wiring layer BM1.

The second contact CB may be implemented as a diagonal pattern or a diagonal contact. The second contact CB may be disposed on the first and fourth gate electrodes GT1 and GT4 and may be connected to the first and fourth gate electrodes GT1 and GT4. Accordingly, the first and fourth gate electrodes GT1 and GT4 may receive the second control signal B through the second contact CB. The second backside contact BCB may be implemented as a diagonal pattern or a diagonal contact. The second backside contact BCB may be disposed under the second and third gate electrodes GT2 and GT3 and may be connected to the second and third gate electrodes GT2 and GT3. The second and third gate electrodes GT2 and GT3 may be connected to the second backside contact BCB through the backside wiring layer BM1. Accordingly, the second and third gate electrodes GT2 and GT3 may receive the first control signal A through the backside wiring layer BM1. The backside wiring layer BM1 may extend in the first direction X between the first and second active regions RX1 and RX2, but the disclosure is not limited thereto. In some embodiments, the backside wiring layer BM1 may extend in the second direction Y. In some embodiments, the backside wiring layer BM1 may partially overlap the first active region RX1 and/or second active region RX2.

According to the present embodiment, an output node may be implemented by using the front-side wiring layer M1, a voltage, for example, the second control signal B may be applied to some of the gate electrodes (e.g., the first and fourth gate electrodes GT1 and GT4) by using the second contact CB disposed in the front-side of the substrate, and a voltage, for example, the first control signal A may be applied to the other gate electrodes (e.g., the second and third gate electrodes GT2 and GT3) by using the backside wiring layer BM1. Thus, the distance between the wirings may be increased compared to the conventional wirings, and accordingly, the routing complexity for the integrated circuit 10b may be reduced.

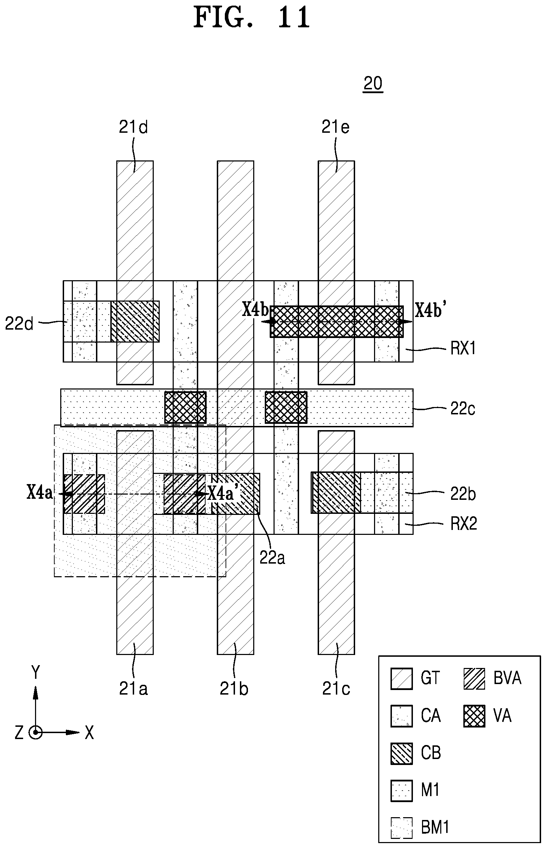

FIG. 11 shows a layout of an integrated circuit 20 according to an embodiment.

Referring to FIG. 11, the integrated circuit 20 may include the first and second active regions RX1 and RX2, the gate electrodes 21a to 21e, the first contacts CA, the second contacts CB, the vias VA, the front-side wiring layer M1, the backside wiring layer BM1, and the backside vias BVA. According to the present embodiment, the backside wiring layer BM1 and the backside vias BVA may form one node, and thus, may constitute a "metal jumper." In addition, according to the present embodiment, the first contacts CA and the via VA may form one node, and thus constitute a "via jumper". Here, the jumper is a relatively short wire for connecting any two points in the integrated circuit 20 or two terminals to each other. In this case, the jumper may include any material having electrical conductivity, for example, polysilicon, a metal, a metal alloy, and the like.

In the front surface of the substrate, the first and second active regions RX1 and RX2 may each extend in a first direction X, and may be apart from each other in a second direction Y. For example, the first and second active regions RX1 and RX2 may have different conductive types. Gate electrodes 21a to 21e may each extend in the second direction Y. The gate electrodes 21d and 21e may cross the first active region RX1, the gate electrodes 21a and 21c may cross the second active region RX2, and the gate electrode 21b may cross the first and second active regions RX1 and RX2. For example, the gate electrodes 21a and 21d may be disposed in a line along the second direction Y, and the gate electrodes 21c and 21e may be disposed in a line along the second direction Y.

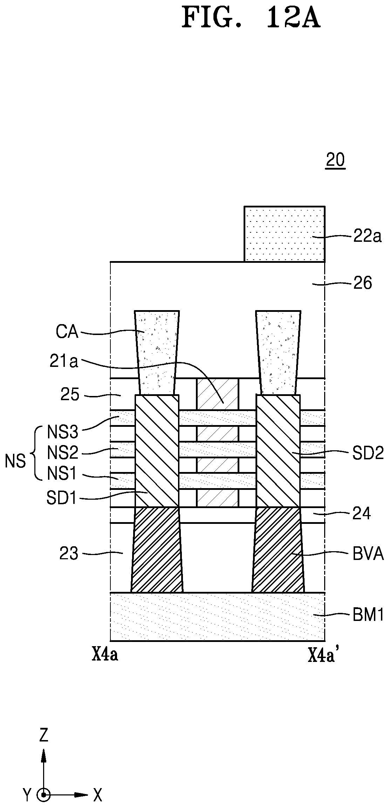

The first contacts CA may be respectively disposed on the source/drain regions of the first active region RX1 and the source/drain regions of the second active region RX2. The second contacts CB may be respectively disposed on the gate electrodes 21b, 21c, and 21d. Each of the gate electrodes 21b, 21c, and 21d may receive the control signal through the second contact CB, thereby supporting the normal operation of the transistor. Accordingly, the gate electrodes 21b, 21c, and 21d may be referred to as "real gate electrodes". The backside vias BVA may be respectively connected to the source/drain regions of the second active region RX2 (the source/drain regions SD1 and SD2 of FIG. 12A). The backside wiring layer BM1 may be connected to the source/drain regions SD1 and SD2 (FIG. 12A) of the second active region RX2 through the backside vias BVA.

The front-side wiring layer M1 may include front-side wiring patterns 22a to 22d each extending in the first direction X. The gate electrodes 21b, 21c, and 21d may be connected to the front-side wiring patterns 22a, 22b, and 22d, respectively, through the second contacts CB. For example, the gate electrode 21b may receive the first control signal A from the front-side wiring pattern 22a through the second contact CB. For example, the gate electrodes 21c and 21d may receive the second control signal B from the front-side wiring patterns 22b and 22d, respectively, through the second contacts CB.

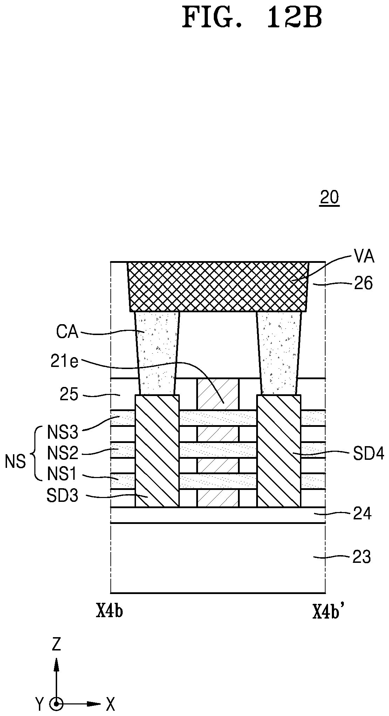

FIG. 12A is a cross-sectional view of the integrated circuit taken along line X4aX4a' of FIG. 11, according to an embodiment, and FIG. 12B is a cross-sectional view of the integrated circuit taken along line X4b-X4b' of FIG. 11, according to an embodiment
Referring to FIGS. 11, 12A, and 12B, a first layer 23 may be a substrate or a semiconductor substrate. A first interlayer insulating layer 24, a second interlayer insulating layer 25, and a third interlayer insulating layer 26 may be sequentially laminated on the first layer 23. The first to third interlayer insulating layers 24, 25, and 26 may include an insulating material. For example, the insulating material may include any one of an oxide film, a nitride film, or an oxynitride film. The upper region of the first layer 23 of FIG. 12A may correspond to the second active region RX2, and the upper region of the first layer 23 of FIG. 12B may correspond to the first active region RX1.

The source/drain regions SD1 and SD2 may be disposed on both sides of the gate electrode 21a. The source/drain regions SD1 and SD2 may include the epitaxial region of the semiconductor material, and may have a different type of doping material from the doping material of the second active region RX2. The backside vias BVA may be respectively connected to the source/drain regions SD1 and SD2, and the backside wiring layer BM1 may be connected to the source/drain regions SD1 and SD2 through the backside vias BVA. Accordingly, the source/drain regions SD1 and SD2 may be electrically connected to each other through a metal jumper including the backside vias BVA and the backside wiring layer BM1, and may receive the same voltage. In this case, the gate electrode 21a may be used as a "dummy gate electrode".

Source/drain regions SD3 and SD4 may be disposed on both sides of the gate electrode 21e. The source/drain regions SD3 and SD4 may include the epitaxial region of the semiconductor material, and may have a different type of doping material from the doping material of the first active region RX1. The first contacts CA may be respectively connected to the source/drain regions SD3 and SD4, and the source/drain regions SD3 and SD4 may be connected to via VA through the first contacts CA. Accordingly, the source/drain regions SD3 and SD4 may be electrically connected to each other through a via jumper including the first contacts CA and the vias VA, and may receive the same voltage. In this case, the gate electrode 21e may be used as a "dummy gate electrode".

In this regard, according to the above embodiment, the integrated circuit 20 may include a metal jumper and a via jumper, and the metal jumper may be implemented by using the backside wiring layer BM1 disposed in the backside of the substrate, and the via jumper may be implemented using the via VA disposed in the front-side of the substrate. In this regard, the integrated circuit 20 may implement jumpers by using the wirings and/or vias disposed in the front-side and the backside of the substrate, thereby improving the routing flexibility and the performance of the integrated circuit 20.

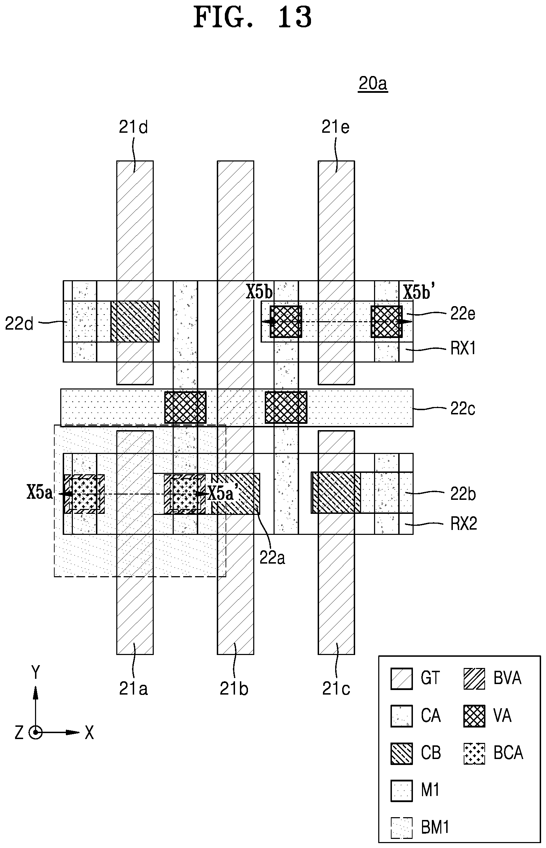

FIG. 13 shows a layout of an integrated circuit 20a according to an embodiment.

Referring to FIG. 13, the integrated circuit 20a may include the first and second active regions RX1 and RX2, the gate electrodes 21a to 21e, the first contacts CA, the second contacts CB, the vias VA, the front-side wiring layer M1, the backside wiring layer BM1, the backside vias BVA, and the first backside contacts BCA. The integrated circuit 20a corresponds to a modified example of the integrated circuit 20 illustrated in FIGS. 11 to 12B, and the descriptions made with reference to FIGS. 11 to 12B may apply to the present embodiment. According to the present embodiment, the backside wiring layer BM1, the backside vias BVA, and the first backside contacts BCA may form one node, and thus may constitute a "metal jumper." In addition, according to the present embodiment, the first contacts CA, the vias VA, and the front-side wiring pattern 22e may form one node, and thus may constitute a "metal jumper."

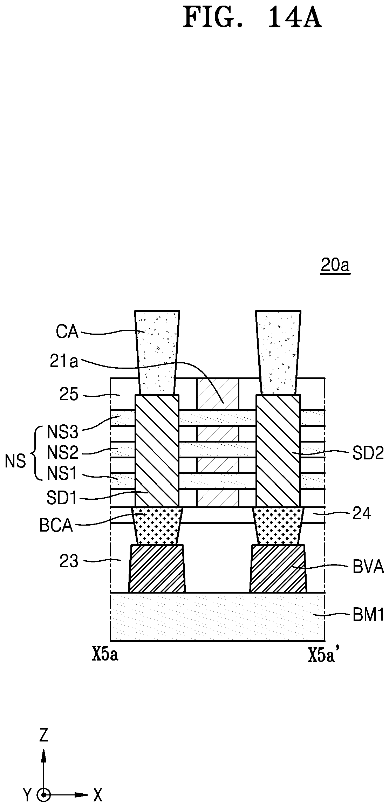

The first backside contacts BCA may be respectively connected to the source/drain regions (the source/drain regions SD1 and SD2 of FIG. 14A) of the second active region RX2. The backside vias BVA may be disposed between the first backside contacts BCA and the backside wiring layer BM1. The backside wiring layer BM1 may be connected to the source/drain regions SD1 and SD2 of the second active region RX2 through the backside vias BVA and the first backside contacts BCA.

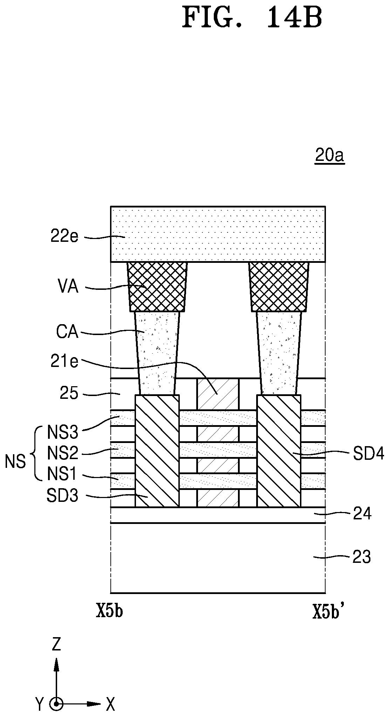

FIG. 14A is a cross-sectional view of the integrated circuit taken along line X5aX5a' of FIG. 13, according to an embodiment, and FIG. 14B is a cross-sectional view of the integrated circuit taken along line X5b-X5b' of FIG. 13, according to an embodiment. The description made above with reference to FIGS. 12A and 12B may also be applied to the present embodiment.

Referring to FIGS. 13, 14A and 14B, the source/drain regions SD1 and SD2 may be disposed on both sides of the gate electrode 21a. The first backside contacts BCA may be respectively connected to the source/drain areas SD1 and SD2, and the backside vias BVA may be respectively connected to the first backside contacts BCA. The backside wiring layer BM1 may be connected to the source/drain regions SD1 and SD2 through the backside vias BVA and the first backside contacts BCA. Accordingly, the source/drain regions SD1 and SD2 may be electrically connected to each other through a metal jumper including the first backside contacts BCA, the backside vias BVA, and the backside wiring layer BM1, and may receive the same voltage. In this case, the gate electrode 21a may be used as a "dummy gate electrode".

The source/drain regions SD3 and SD4 may be disposed on both sides of the gate electrode 21e. The first contacts CA may be respectively connected to the source/drain regions SD3 and SD4, and the vias VA may be respectively connected to the first contacts CA. The front-side wiring pattern 22e may be connected to the source/drain regions SD3 and SD4 through the vias VA and the first contacts CA. Accordingly, the source/drain regions SD3 and SD4 may be electrically connected to each other through a metal jumper including the first contacts CA, the vias VA, and the front-side wiring pattern 22e, and may receive the same voltage. In this case, the gate electrode 21e may be used as a "dummy gate electrode".

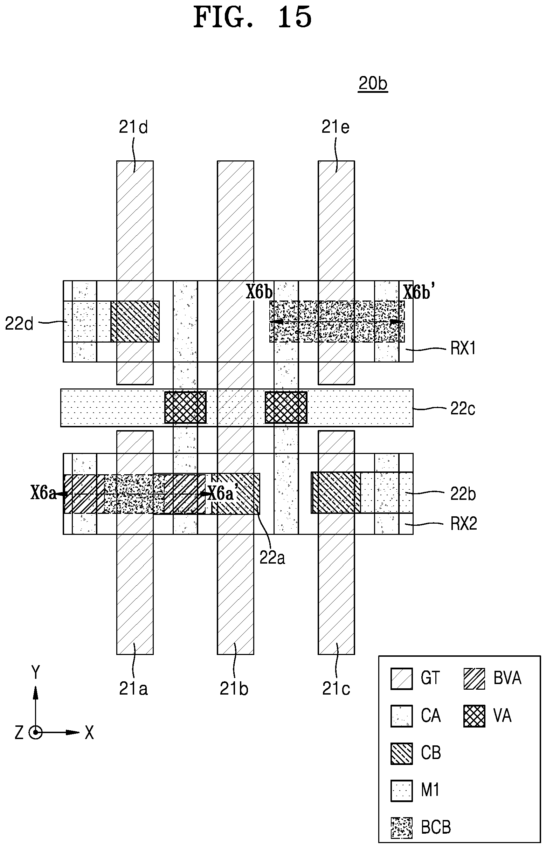

FIG. 15 shows a layout of an integrated circuit 20b according to an embodiment.

Referring to FIG. 15, the integrated circuit 20b may include the first and second active regions RX1 and RX2, the gate electrodes 21a to 21e, the first contacts CA, the second contacts CB, the vias VA, the front-side wiring layer M1, the backside vias BVA, and the second backside contacts BCB. The integrated circuit 20b corresponds to a modified example of the integrated circuit 20 illustrated in FIGS. 11 to 12B, and the descriptions made with reference to FIGS. 11 to 12B may apply to the present embodiment. According to the present embodiment, the backside vias BVA and the second backside contact BCB may form one node, and thus constitute a "contact jumper."

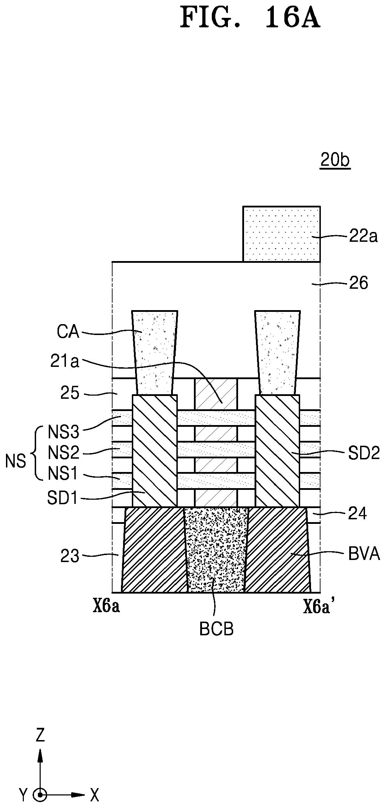

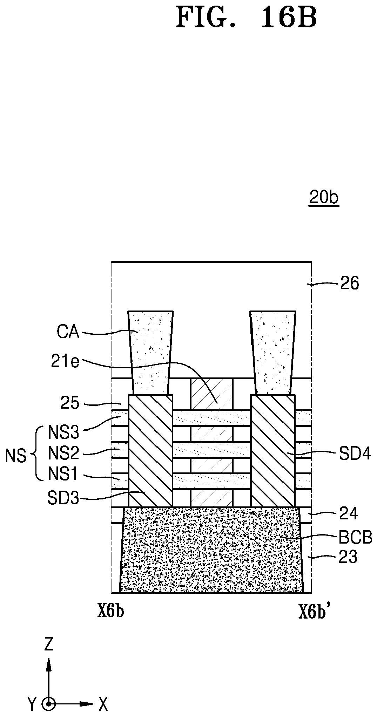

Under the second active region RX2, the backside vias BVA may be respectively connected to the source/drain regions SD1 and SD2 (FIG. 16A) of the second active region RX2, and the second backside contact BCB may be connected to the gate electrode 21a. In an embodiment, under the second active region RX2, the backside vias BVA and the second backside contact BCB may be electrically connected to each other. Under the first active region RX1, the second backside contact BCB may extend in the first direction X, and may be connected to the source/drain regions SD3 and SD4 (FIG. 16B) of the first active region RX1.

In an embodiment, the backside vias BVA and the second backside contact BCB may be implemented as the same layer, and thus, may be formed using the same mask. In an embodiment, the backside vias BVA and the second backside contact BCB may be implemented as different layers, and thus, may be formed using different masks. In an embodiment, at least one of the backside vias BVA may be in contact with the second backside contact BCB. However, the inventive concept is not limited thereto, and the backside vias BVA may not be in contact with the second backside contact BCB.

FIG. 16A is a cross-sectional view of the integrated circuit taken along line X6aX6a' of FIG. 15, according to an embodiment, and FIG. 16B is a cross-sectional view of the integrated circuit taken along line X6b-X6b' of FIG. 15, according to an embodiment. The description made above with reference to FIGS. 12A and 12B may also be applied to the present embodiment.

Referring to FIGS. 15, 16A and 16B, the source/drain regions SD1 and SD2 may be disposed on both sides of the gate electrode 21a. The backside vias BVA may be respectively connected to the source/drain areas SD1 and SD2, and the second backside contact BCB may be connected to the gate electrode 21a. The backside vias BVA and the second backside contact BCB may be connected to each other. Accordingly, the source/drain regions SD1 and SD2 may be electrically connected to each other through a contact jumper including the second backside contacts BCB and the backside via BVA, and may receive the same voltage. In this case, the gate electrode 21a may be used as a "dummy gate electrode".

The source/drain regions SD3 and SD4 may be disposed on both sides of the gate electrode 21e. The second backside contact BCB may extend in the first direction X and be connected to the source/drain regions SD3 and SD4. Accordingly, the source/drain regions SD3 and SD4 may be electrically connected to each other through a contact jumper including the second backside contact BCB, and may receive the same voltage. In this case, the gate electrode 21e may be used as a "dummy gate electrode". In addition, the first contacts CA may further be respectively disposed on the source/drain regions SD3 and SD4.

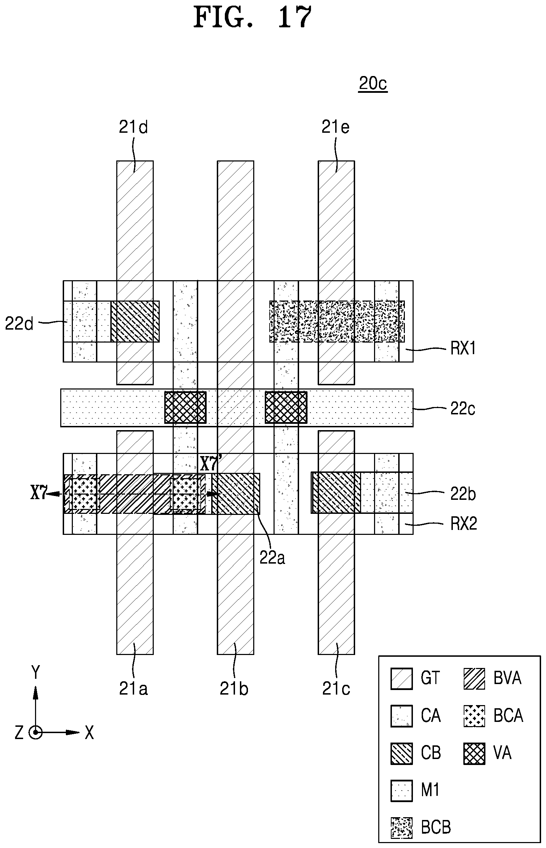

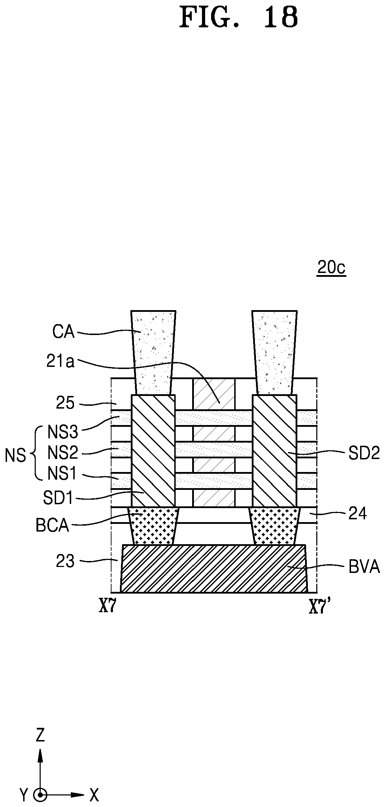

FIG. 17 shows a layout of an integrated circuit 20c according to an embodiment. FIG. 18 is a cross-sectional view of the integrated circuit taken along line X7-X7' of FIG. 17, according to an embodiment.

Referring to FIGS. 17 and 18, the integrated circuit 20c may include the first and second active regions RX1 and RX2, the gate electrodes 21a to 21e, the first contacts CA, the second contacts CB, the vias VA, the front-side wiring layer M1, the backside via BVA, and the first backside contacts BCA. The integrated circuit 20c corresponds to a modified example of the integrated circuit 20b illustrated in FIGS. 15 to 16B, and the descriptions made with reference to FIGS. 15 to 16B may apply to the present embodiment. According to the present embodiment, the backside via BVA and the first backside contacts BCA may form one node, and thus constitute a "contact jumper."

The source/drain regions SD1 and SD2 may be disposed on both sides of the gate electrode 21a. The first backside contacts BCA may be respectively connected to the source/drain areas SD1 and SD2, and the backside via BVA may be connected to the first backside contacts BCA. The backside via BVA and the first backside contacts BCA may be connected to each other. Accordingly, the source/drain regions SD1 and SD2 may be electrically connected to each other through a contact jumper including the first backside contacts BCA and the backside via BVA, and may receive the same voltage. In this case, the gate electrode 21a may be used as a "dummy gate electrode".

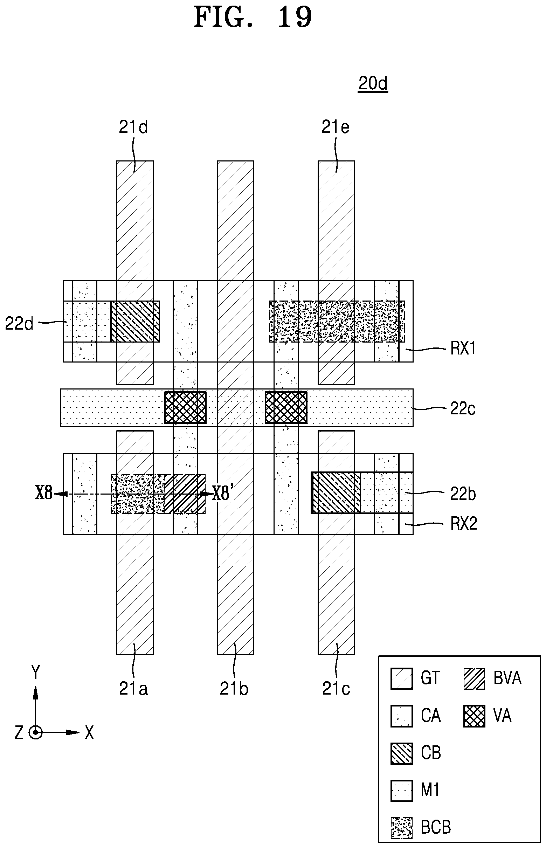

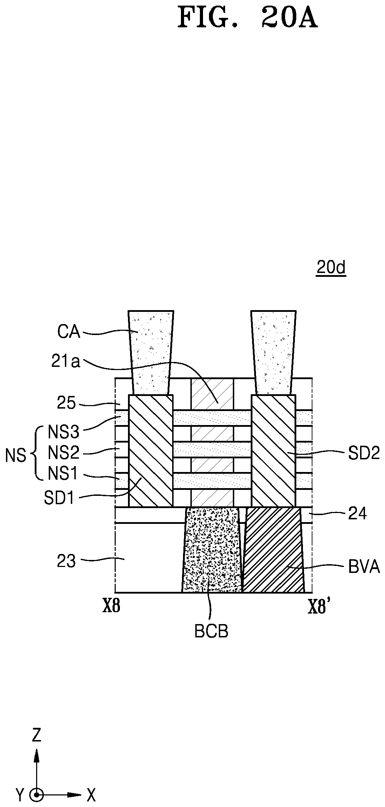

FIG. 19 shows a layout of an integrated circuit 20d according to an embodiment. FIG. 20A is a cross-sectional view of the integrated circuit taken along line X8-X8' of FIG. 19, according to an embodiment.

Referring to FIGS. 19 and 20A, the integrated circuit 20d may include the first and second active regions RX1 and RX2, the gate electrodes 21a to 21e, the first contacts CA, the second contacts CB, the vias VA, the front-side wiring layer M1, the backside via BVA, and the second backside contacts BCB. The integrated circuit 20d corresponds to a modified example of the integrated circuit 20b illustrated in FIGS. 15 to 16B, and the descriptions made with reference to FIGS. 15 to 16B may apply to the present embodiment. According to the present embodiment, the backside via BVA and the second backside contact BCB may form one node, and thus constitute a "half contact jumper."

The source/drain regions SD1 and SD2 may be disposed on both sides of the gate electrode 21a. The second backside contact BCB may be connected to the gate electrode 21a, and the backside via BVA may be connected to the source/drain region SD2. The backside via BVA and the second backside contact BCB may be connected to each other. For example, the bottom level of the second backside contact BCB and the backside via BVA may be substantially identical. Accordingly, the source/drain region SD2 and the gate electrode 21a may be electrically connected to each other through a half contact jumper including the second backside contact BCB and the backside via BVA, and may receive the same voltage, for example, a first voltage. In this case, the gate electrode 21a may be used as a "dummy gate electrode".

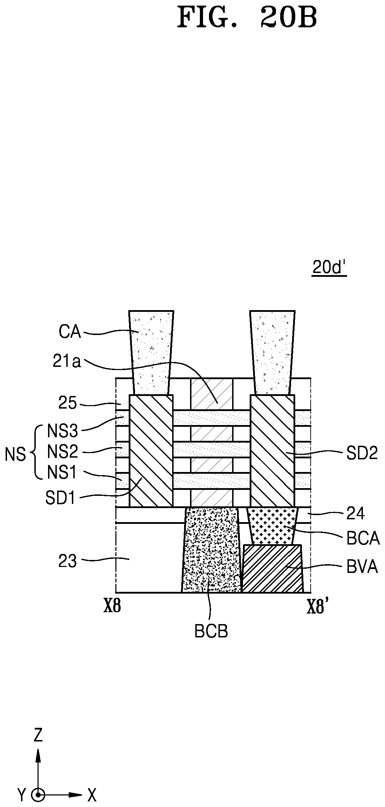

In FIG. 20A, a configuration in which the backside via BVA is connected to the source/drain region SD2 is shown as an example, but the inventive concept is not limited thereto, and the first backside contact (e.g., the first backside contact BCA of FIG. 20B) may be disposed in the source/drain region instead of the backside via BVA. In this case, the bottom level of the second backside contact BCB and the first backside contact BCA may be substantially identical. Accordingly, the source/drain region SD2 and the gate electrode 21a may be electrically connected to each other through a half contact jumper including the second backside contact BCB and the first backside contact BCA, and may receive the same voltage, for example, the first voltage. In this case, the gate electrode 21a may be used as a "dummy gate electrode".

FIG. 20B is a cross-sectional view of the integrated circuit taken along line X8-X8' of FIG. 19, according to an embodiment.

Referring to FIGS. 19 and 20B, the integrated circuit 20d' may further include the first backside contact BCA, which is not included in the integrated circuit 20. According to the present embodiment, the backside via BVA, the first backside contact BCA, and the second backside contact BCB may form one node, and thus constitute a "half contact jumper."

The first backside contact BCA may be disposed under the source/drain region SD2 and be connected to the source/drain region SD2. The backside via BVA may be disposed under the first backside contact BCA and be connected to the first backside contact BCA. The second backside contact BCB may be connected to the gate electrode 21a. In this case, the bottom level of the second backside contact BCB and the backside via BVA may be substantially identical. The backside via BVA, the first backside contact BCA, and the second backside contact BCB may be connected to one another. Accordingly, the source/drain region SD2 and the gate electrode 21a may be electrically connected to each other through a half contact jumper including the first backside contact BCA, the second backside contact BCB and the backside via BVA, and may receive the same voltage. In this case, the gate electrode 21a may be used as a "dummy gate electrode".

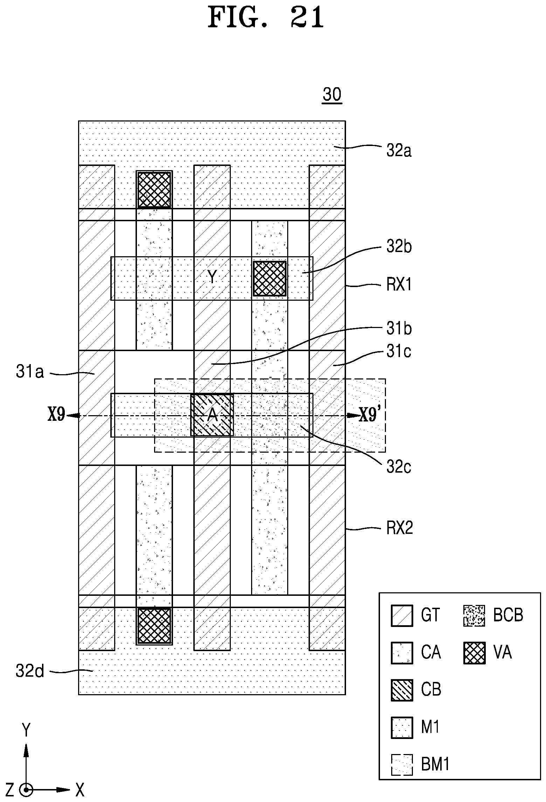

FIG. 21 shows a layout of an integrated circuit 30 according to an embodiment.

Referring to FIG. 21, the integrated circuit 30 may include the standard cell, and the standard cell may include the first and second active regions RX1 and RX2, the gate electrodes GT, the first contacts CA, the second contact CB, the vias VA, the front-side wiring layer M1, the backside wiring layer BM1, and the second backside contact BCB. The gate electrodes GT may include gate electrodes 31a, 31b, and 31c each extending in the second direction Y. The first contacts CA may be sources/drain contacts connected to source/drain regions, and the second contact CB may be a gate contact connected to the gate electrode 31b. The vias VA may be disposed between the first contacts CA and the front-side wiring layer M1.

The front-side wiring layer M1 may include the front-side wiring patterns 32a to 32d, each extending in the first direction X and being apart in the second direction Y. The front-side wiring pattern 32c may correspond to the input pin of the standard cell and may, for example, receive the first control signal A. The front-side wiring pattern 32b may correspond to the output pin of the standard cell, and may, for example, correspond to the output node (e.g., the output node Y). For example, the front-side wiring pattern 32a may overlap the upper boundary of the standard cell, and a positive supply voltage, for example, the power supply voltage VDD may be applied. For example, the front-side wiring pattern 32d may overlap the lower boundary of the standard cell, and a negative supply voltage, for example, the ground voltage VSS may be applied.

The backside wiring layer BM1 may extend in the first direction X. The backside wiring layer BM1 may correspond to the input pin of the standard cell and may, for example, receive the first control signal A. For example, the backside wiring layer BM1 may extend in the first direction X in the dummy region between the first and second active regions RX1 and RX2. However, the inventive concept is not limited thereto, and the backside wiring layer BM1 may at least partially overlap at least one of the first and second active regions RX1 and RX2.

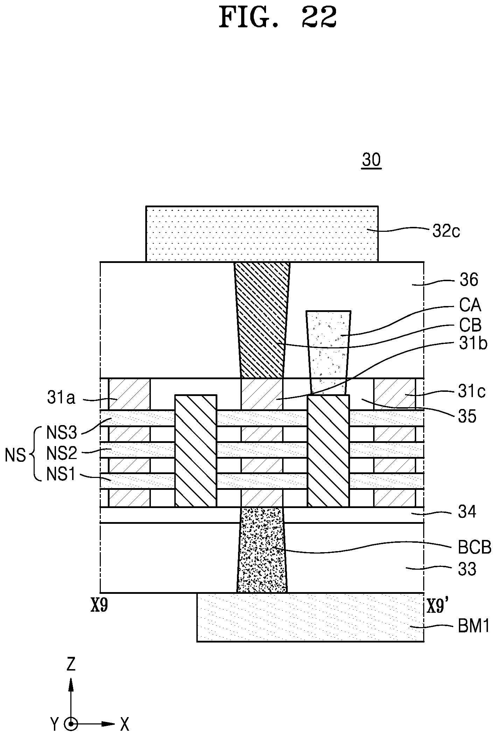

FIG. 22 is a cross-sectional view of the integrated circuit taken along line X9-X9' of FIG. 21, according to an embodiment.

Referring to FIG. 22, the first layer 33 may be a substrate or an insulating layer, and a first interlayer insulating layer 34, a second interlayer insulating layer 35, and a third interlayer insulating layer 36 may be sequentially stacked on a first layer 33. The gate electrodes 31a, 31b, and 31c may be apart from one another in the first direction X on the first interlayer insulating layer 34. The first contact CA may extend in the second direction Y between the gate electrodes 31b and 31c.

The second contact CB may be disposed on the gate electrode 31b, and the front-side wiring pattern 32c may be disposed on the second contact CB. The second backside contact BCB may be disposed under the gate electrode 31b, and may be connected to the backside wiring layer BM1. In this regard, the gate electrode 31b may be connected to both the front-side wiring pattern 32c of the front-side wiring layer M1 and the backside wiring layer BM1, and accordingly, the gate electrode 31b may be referred to as a "double gate."

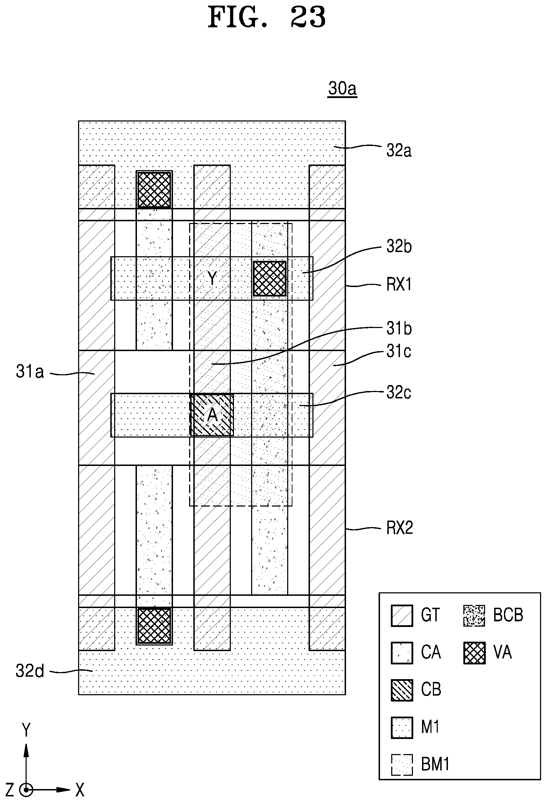

FIG. 23 shows a layout of an integrated circuit 30a according to an embodiment.

Referring to FIG. 23, the integrated circuit 30a corresponds to a modified example of the integrated circuit 30 of FIG. 21, and the descriptions made with reference to FIGS. 21 and 22 may apply to the present embodiment. The backside wiring layer BM1 included in the integrated circuit 30a may extend in the second direction Y. The backside wiring layer BM1 may at least partially overlap the first and second active regions RX1 and RX2. However, the inventive concept is not limited thereto, and the backside wiring layer BM1 may extend to at least partially overlap at least one of the front-side wiring patterns 32a and 32d.

According to the above-described embodiments with reference to FIGS. 21 to 23, the integrated circuits 30 and 30a may include a gate electrode 31b connected to each of the front-side wiring layer M1 disposed above the front-side of the substrate and the backside wiring layer BM1 disposed on the backside of the substrate. In this regard, by applying a control signal to the gate electrode 3 1b by using the front-side wiring layer M1 and the backside wiring layer BM1, the efficiency of signal transmission may be improved, such as a reduction in the resistance of the signal wiring, and, as a result, the performance of the integrated circuits 30 and 30a may be improved. In addition, in some embodiments, a voltage may be applied to the source region by using the front-side wiring layer M1 and the backside wiring layer BM1, and the source may be referred to as a "double source." In addition, in some embodiments, a voltage may be applied to the drain region by using the front-side wiring layer M1 and the backside wiring layer BM1, and the drain may be referred to as a "double drain."

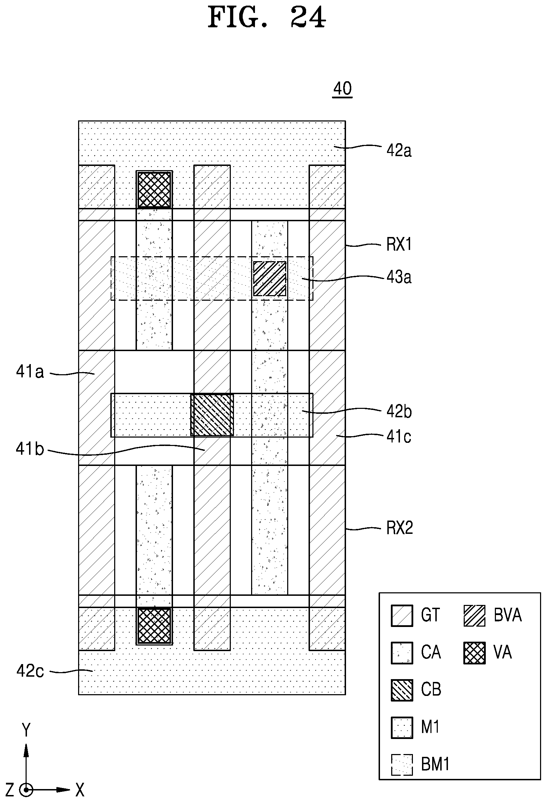

FIG. 24 shows a layout of an integrated circuit 40 according to an embodiment.

Referring to FIG. 24, the integrated circuit 40 may include the standard cell, and the standard cell may include the first and second active regions RX1 and RX2, the gate electrodes GT, the first contacts CA, the second contact CB, the vias VA, the front-side wiring layer M1, the backside wiring layer BM1, and the backside via BVA. According to the present embodiment, power is supplied to the standard cell by using the front-side wiring layer M1, the input pin of the standard cell may be implemented by using the front-side wiring layer M1, and the output pin of the standard cell may be implemented by using the backside wiring layer BM1.

The gate electrodes GT may include gate electrodes 41a to 41c being apart in the first direction X and each extending in the second direction Y. The first contacts CA may be sources/drain contacts connected to source/drain regions, and the second contact CB may be a gate contact connected to the gate electrode 41b. The vias VA may be disposed between the first contacts CA and the front-side wiring layer M1.

The front-side wiring layer M1 may include the front-side wiring patterns 42a to 42c, each extending in the first direction X and being apart in the second direction Y. The backside wiring layer BM1 may include the backside wiring pattern 43a extending in the first direction X. The backside wiring pattern 43a may be disposed under the first active region RX1 in a vertical direction Z. The front-side wiring pattern 42b may correspond to the input pin of the standard cell and may, for example, receive the first control signal A. The backside wiring pattern 43a may correspond to the output pin or the output node (e.g., the output node Y) of the standard cell.

For example, the front-side wiring pattern 42a may overlap the upper boundary of the standard cell, and a positive supply voltage, for example, the power supply voltage VDD may be applied. For example, the front-side wiring pattern 42c may overlap the lower boundary of the standard cell, and a negative supply voltage, for example, the ground voltage VSS may be applied.

However, the inventive concept is not limited thereto, and in some embodiments, the positive supply voltage is transmitted to the standard cell by using the front-side wiring layer M1, and the negative supply voltage is transmitted to the standard cell by using the backside wiring layer BM1. In some embodiments, a negative supply voltage may be transmitted to the standard cell by using the front-side wiring layer M1, and a positive supply voltage may be transmitted the standard cell using the backside wiring layer BM1. In some embodiments, the backside wiring layer BM1 may be used to transmit the positive supply voltage and the negative supply voltage to the standard cell.

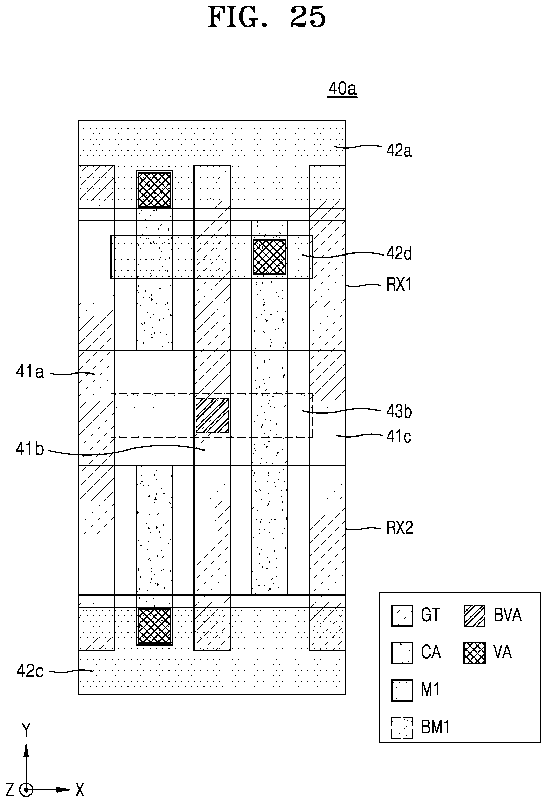

FIG. 25 shows a layout of an integrated circuit 40a according to an embodiment.

Referring to FIG. 25, the integrated circuit 40a corresponds to a modified example of the integrated circuit 40 of FIG. 24, and the descriptions made with reference to FIG. 24 may apply to the present embodiment. According to the present embodiment, power is supplied to the standard cell by using the front-side wiring layer M1, the output pin of the standard cell may be implemented by using the front-side wiring layer M1, and the input pin of the standard cell may be implemented by using the backside wiring layer BM1.

The front-side wiring layer M1 may include the front-side wiring patterns 42a, 42c, and 42d, each extending in the first direction X and being apart in the second direction Y. The backside wiring layer BM1 may include the backside wiring patterns 43b extending in the first direction X. The backside wiring pattern 43b may extend in the first direction X between the first and second active regions RX1 and RX2. The backside wiring pattern 43b may correspond to the input pin of the standard cell and may, for example, receive the first control signal A, and the front-side wiring pattern 42d may correspond to the output pin or the output node (e.g., the output node Y).

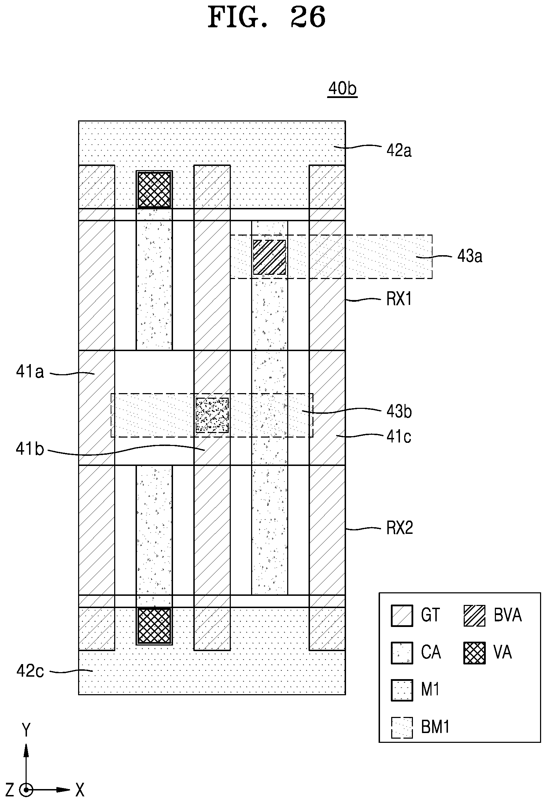

FIG. 26 shows a layout of an integrated circuit 40b according to an embodiment.

Referring to FIG. 26, the integrated circuit 40b corresponds to a modified example of the integrated circuit 40 of FIG. 24, and the descriptions made with reference to FIG. 24 may apply to the present embodiment. According to the present embodiment, power is applied to the standard cell by using the front-side wiring layer M1, and the input pin and output pin of the standard cell may be implemented using the backside wiring layer BM1.

The front-side wiring layer M1 may include the front-side wiring patterns 42a and 42c, each extending in the first direction X and being apart in the second direction Y. The backside wiring layer BM1 may include the backside wiring patterns 43a and 43b each extending in the first direction X. The backside wiring pattern 43a may be disposed under the first active region RX1, and the backside wiring pattern 43b may be disposed between the first and second active regions RX1 and RX2. The backside wiring pattern 43b may correspond to the input pin of the standard cell and may, for example, receive the first control signal A, and the backside wiring pattern 43a may correspond to the output pin or the output node (e.g., the output node Y).

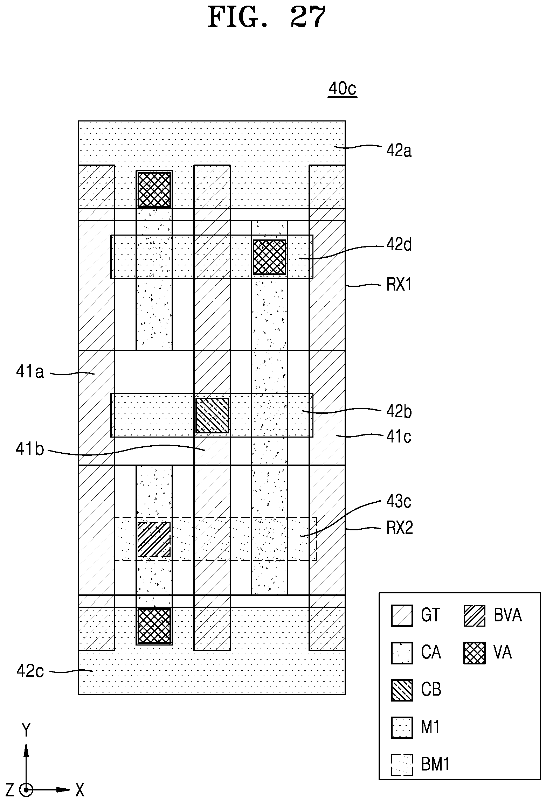

FIG. 27 shows a layout of an integrated circuit 40c according to an embodiment.

Referring to FIG. 27, the integrated circuit 40c corresponds to a modified example of the integrated circuit 40 of FIG. 24, and the descriptions made with reference to FIG. 24 may apply to the present embodiment. According to the present embodiment, power is supplied to the standard cell by using the front-side wiring layer M1, the input pin and output pin of the standard cell may be implemented by using the front-side wiring layer M1, and an internal net of the standard cell may be implemented by using the backside wiring layer BM1.

The front-side wiring layer M1 may include the front-side wiring patterns 42a, 42b, 42c, and 42d, each extending in the first direction X and being apart in the second direction Y. The backside wiring layer BM1 may include the backside wiring pattern 43c extending in the first direction X. The backside wiring pattern 43c may be disposed under the second active region RX2. The front-side wiring pattern 42b may correspond to the input pin of the standard cell and may, for example, receive the first control signal A. The front-side wiring pattern 42d may correspond to the output pin or the output node (e.g., the output node Y) of the standard cell. The backside wiring pattern 43c may correspond to the internal net of the standard cell and for example, may receive an internal signal of the standard cell.

According to the above embodiments described with reference to FIGS. 24 to 27, the integrated circuits 40, 40a, 40b, and 40c may variously implement the input pin, the output pin, and/or the internal net of the standard cell by using the front-side wiring layer M1 disposed above the front-side of the substrate and the backside wiring layer BM1 disposed on the backside of the substrate. In this regard, by distributing and arranging various wirings connected to the standard cell in the front-side wiring layer M1 and the backside wiring layer BM1, the efficiency of signaling may be improved by, for example, reducing the resistance of the signal wiring. As a result, the performance of the integrated circuits 40, 40a, 40b, and 40c may be improved.

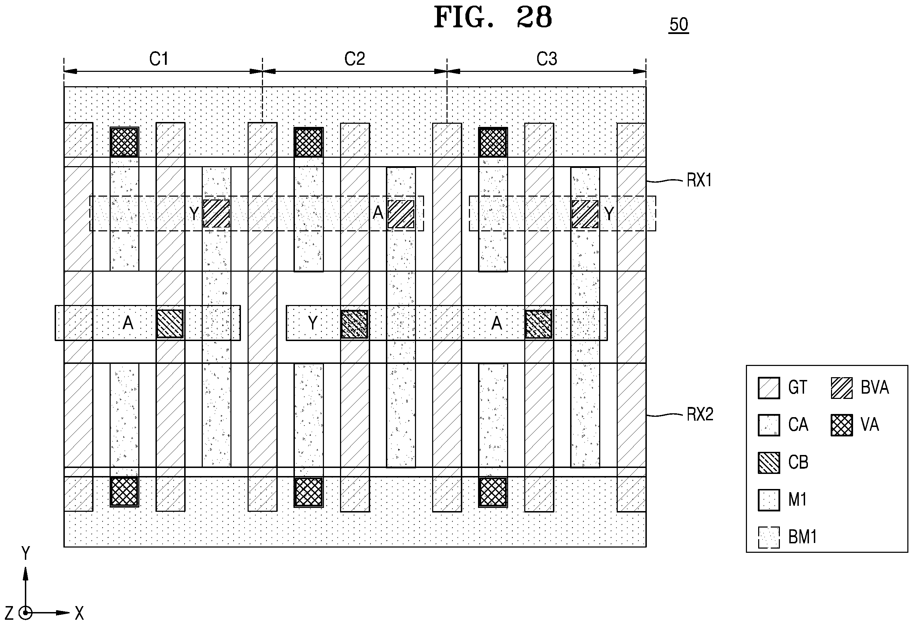

FIG. 28 shows a layout of an integrated circuit 50 according to an embodiment.

Referring to FIG. 28, the integrated circuit 50 may include a plurality of standard cells including first to third standard cells C1, C2, and C3. The first to third standard cells C1, C2, and C3 may be closely positioned to each other in the first direction X. The first to third standard cells C1, C2, and C3 may include the first and second active regions RX1 and RX2, the gate electrodes GT, the first contacts CA, the second contact CB, the vias VA, the front-side wiring layer M1, the backside wiring layer BM1, and the backside vias BVA. The front-side wiring layer M1 may include the front-side wiring pattern extending in, for example, the first direction X, between the first and second active regions RX1 and RX2. The backside wiring layer BM1 may include the backside wiring pattern extending, for example, in the first direction X, under the first active region RX1.

In an embodiment, in the first standard cell C1, the input pin (e.g., region A) may be implemented as the front-side wiring pattern, and the output pin (e.g., the output node Y) may be implemented as the backside wiring pattern. In an embodiment, in the second standard cell C2, the input pin (e.g., region A) may be implemented as the backside wiring pattern, and the output pin (e.g., the output node Y) may be implemented as the front-side wiring pattern. In an embodiment, in the third standard cell C3, the input pin (e.g., region A) may be implemented as the front-side wiring pattern, and the output pin (e.g., the output node Y) may be implemented as the backside wiring pattern.

At least one of the standard cells included in the integrated circuit 50 may be implemented as at least one of the integrated circuits 40, 40a, 40b, and 40c illustrated in FIGS. 24 to 27. In an embodiment, some of the standard cells included in the integrated circuit 50 may implement the input pin and/or the output pin by using the front-side wiring layer, and the other standard cells may implement the input pin and/or the output pin by using the backside wiring layer. In an embodiment, some of the standard cells included in the integrated circuit 50 may perform routing by using the front-side wiring layer, and the other standard cells may perform routing by using the backside wiring layer. In an embodiment, at least some of the standard cells included in the integrated circuit 50 may perform routing using both the front-side wiring layer and the backside wiring layer.

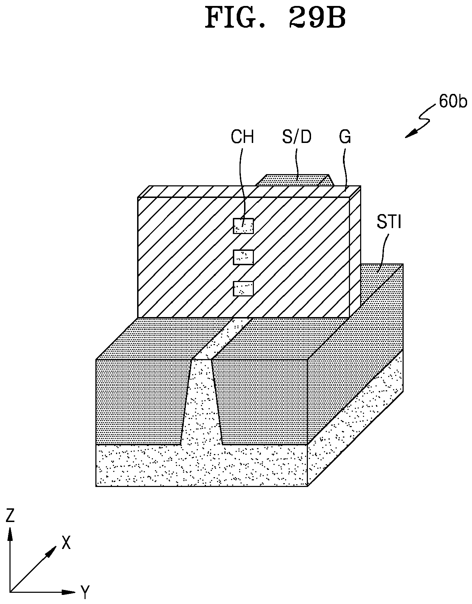

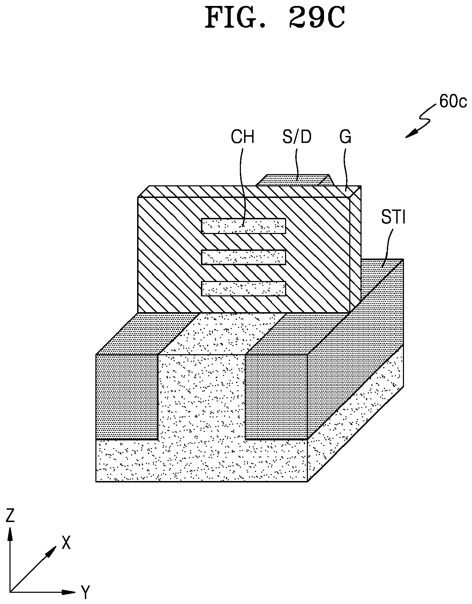

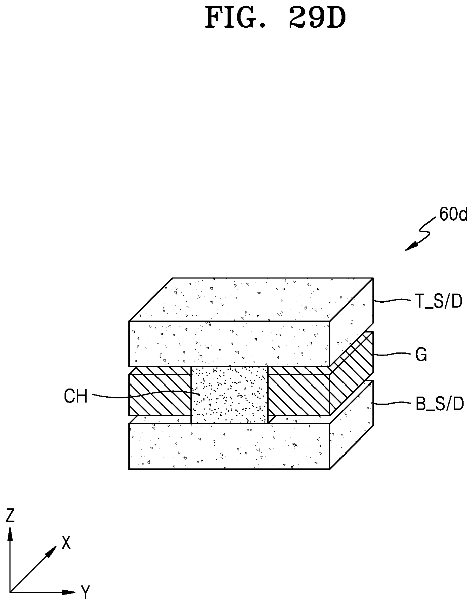

FIGS. 29A to 29D each show a device according to some embodiments. For example, FIG. 29A shows a FinFET 60a, FIG. 29B shows a gate-all-around field effect transistor (GAAFET) 60b, FIG. 29C shows a multi-bridge channel field effect transistor (MBCFET) 60c, and FIG. 29D shows a vertical field effect transistor (VFET) 60d. For convenience of illustration, FIGS. 29A to 29C shows that one of the two sources/drain regions is removed, and FIG. 29D shows a cross section of the VFET 60d cut with a plane that is parallel to a plane consisting of the second direction Y and the vertical direction Z and that passes through a channel CH of the VFET 60d.

Referring to FIG. 29A, the FinFET 60a may be formed with an active pattern that extends as a fin shape in the first direction X between the STIs, and a gate G that extends in the second direction Y. The source/drain S/D may be formed on both sides of the gate G, and accordingly, the source and drain may be separated from each other in the first direction X. An insulating layer may be formed between the channel CH and the gate G. In some embodiments, the FinFET 60a may be formed with a plurality of active patterns, which are spaced apart from one another in the second direction Y, and along with corresponding gates G.

Referring to FIG. 29B, the GAAFET 60b may be formed by using active patterns, specifically nanowires, which are spaced apart from each other in the vertical direction Z while extending in the first direction X. The gate G extends in the second direction Y. The source/drain S/D may be formed on both sides of the gate G, and accordingly, the source and drain may be spaced apart from each other in the first direction X. An insulating layer may be formed between the channel CH and the gate G. The number of nanowires included in the GAAFET 60b is not limited to that shown in FIG. 29B.

Referring to FIG. 29C, the MBCFET 60c may be formed by active patterns, that is, nanosheets, apart from each other in the vertical direction Z and extending in the first direction X, and the gate G extending in the second direction Y. The source/drain S/D may be formed on both sides of the gate G, and accordingly, the source and drain may be apart from each other in the first direction X. An insulating layer may be formed between the channel CH and the gate G. The number of nanosheets included in the MBCFET 60c is not limited to that shown in FIG. 29C.

Referring to FIG. 29D, the VFET 60d may include a top source/drain T_SID and a bottom source/drain B_S/D that are apart from each other in the vertical direction Z with the channel CH therebetween. The VFET 60d may include the gate G surrounding the circumference of the channel CH between the top source/drain T_S/D and the bottom source/drain B_S/D. An insulating layer may be formed between the channel CH and the gate G.

In the present specification, an integrated circuit including the FinFET 60a or the MBCFET 60c is mainly described, but elements included in the integrated circuit are not limited to the embodiments of FIGS. 29A to 29D. For example, the integrated circuit may include a ForkFET having a structure in which an N-type transistor and a P-type transistor are closer to each other by separating nanosheets for the P-type transistor from nanosheets for N-type transistor with a dielectric wall. In addition, the integrated circuit may include a bipolar bonding transistor as well as FETs such as CFET, NCFET, CNT FET, etc.

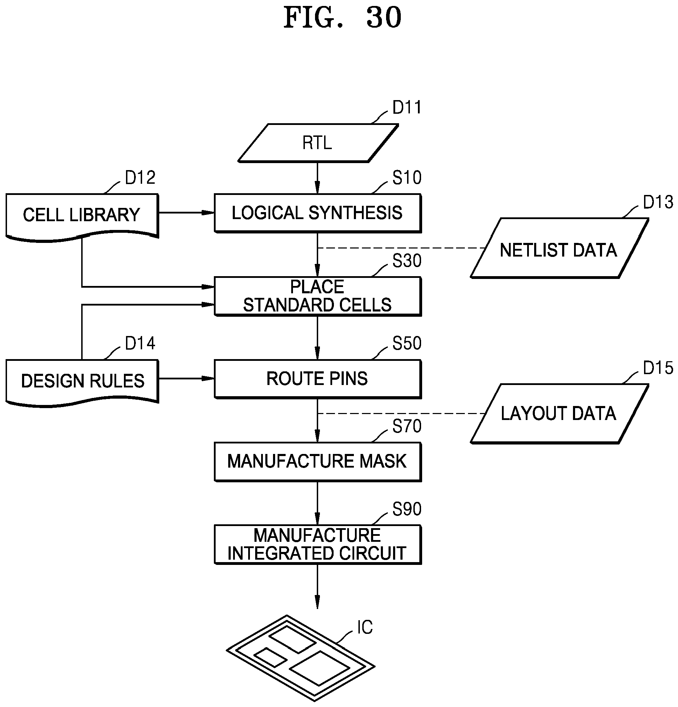

FIG. 30 is a flowchart of a method for manufacturing an integrated circuit, according to an embodiment.

Referring to FIG. 30, the method, according to the present embodiment, for preparing an integrated circuit IC including the standard cells, may include a plurality of operations S10, S30, S50, S70, and S90. The standard cell is a unit of layout included in the integrated circuit and may be designed to perform a predefined function. The cell library (or standard cell library) D12 may include information about the standard cells, such as functions, characteristics, layouts, etc. In some embodiments, the cell library D12 may not only define functional cells that generate output signals from the input signal, but may also define tap cells and dummy cells. In some embodiments, the cell library D12 may define memory cells and dummy cells having the same footprint. Design rules D14 may include requirements to be complied by the layout of the integrated circuit IC. For example, the design rules D14 may include requirements for spaces between patterns, a minimum width of patterns, routing directions of wiring layers, etc. in the same layer. In some embodiments, the design rules D14 may define the minimum separation space between the wiring layers in the same track.

In operation S10, a logical synthesis operation of generating netlist data D13 from register-transfer level (RTL) data D11 may be performed. For example, the semiconductor design tool (e.g., a logical synthesis tool) may perform logic synthesis by referring to a cell library D12 from the RTL data prepared with hardware description language (HDL) such as VHSIC hardware description language (VHDL) and Verilog, and may generate netlist data D13 including a bitstream or a netlist. The netlist data D13 may correspond to the input of the place and routing described later.

In step S30, the standard cells may be placed. For example, the semiconductor design tool (e.g., a P&R tool) may place the standard cells used in the netlist data D13 by referring to the cell library D12. In some embodiments, the semiconductor design tool may dispose the standard cell on a row extending in the X axis direction or the Y axis direction, and the disposed standard cell may receive power from a power rail extending along boundaries of the row.

In operation S50, the pins of the standard cells may be routed. For example, the semiconductor design tool may generate interconnections that electrically connect the output pins and input pins of the disposed standard cells to each other, and may generate layout data D15 defining disposed standard cells and generated interconnections. The interconnection may include the via of the via layer and/or the patterns of the wiring layers. The wiring layers may include the front-side wiring layer disposed above the front-side of the substrate and the backside wiring layer disposed on the backside of the substrate. The layout data D15 may have a format such as GDSII, and may include geometric information of cells and interconnections. The semiconductor design tool may refer to the design rules D14 while routing the pins of the cells. The layout data D15 may correspond to the output of the place and routing. Operation S50 alone or both of operations S30 and S50 may be referred to as a method of designing the integrated circuit.

In an embodiment, the integrated circuit may include a cross-coupled structure, may implement some of the wirings of the cross-coupled structure by using at least one front-side wiring layer, at least one front-side contact, and/or at least one front-side via disposed above the front-side of the substrate, and may implement other wirings of the cross-coupled structure by using at least one backside wiring layer, at least one backside contact, and/or at least one backside via disposed on the backside of the substrate.

In an embodiment, the integrated circuit may include a contact jumper, a metal jumper, and/or a via jumper, may implement the contact jumper, the metal jumper, or the via jumper by using at least one front-side wiring layer, at least one front-side contact, and/or at least one front-side via disposed above the front-side of the substrate, and may implement the contact jumper, the metal jumper, or the via jumper by using at least one backside wiring layer, at least one backside contact, and/or at least one backside via disposed on the backside of the substrate.

In one embodiment, the integrated circuit may include a double gate, a double source and/or a double drain. For example, at least one front-side wiring layer, at least one front-side contact, and/or at least one front-side via disposed above the front-side of the substrate, and at least one backside wiring layer, at least one backside contact, and/or at least one backside via disposed on the backside of the substrate may be connected to the same gate electrode.

In an embodiment, the integrated circuit may include an input pin, an output pin, an internal net, and/or a power line, may implement at least one of the input pin, the output pin, the internal net, and the power line by using at least one front-side wiring layer, at least one front-side contact, and/or at least one front-side via disposed above the front-side of the substrate, and may implement the input pin, the output pin, the internal net, and the power line by using at least one backside wiring layer, at least one backside contact, and/or at least one backside via disposed on the backside of the substrate.

In operation S70, an operation of fabricating a mask may be performed. For example, an optical proximity correction (OPC) to correct distortions such as refraction due to the characteristics of light in photolithography may be applied to the layout data D15. The patterns on the mask may be defined to form patterns disposed on the plurality of layers based on data to which the OPC is applied, and at least one mask (or a photomask) for forming each pattern of plurality of layers may be manufactured. In some embodiments, the layout of the integrated circuit IC may be limitedly modified in operation S70, and the limitedly modifying of the integrated circuit IC in operation S70, which is an after process to optimize the structure of the integrated circuit IC, may be referred to as design polishing.

In operation S90, an operation of manufacturing the integrated circuit IC may be performed. For example, the integrated circuit IC may be manufactured by patterning a plurality of layers by using at least one mask manufactured in operation S70. A front-end-of-line (FEOL) may include, for example, planarization and cleaning of a wafer, forming a trench, forming a well, forming a gate electrode, and forming a source and a drain. Through the FEOL, individual elements, such as transistors, capacitors, resistance, etc. may be formed on the substrate. In addition, back-end-of-line (BEOL), may include, for example, silicidation of gate, source, and drain regions, adding a dielectric material, planarization, forming a hole, adding a metal layer, forming a via, forming a passivation layer, etc. Through the BEOL, individual elements, such as transistors, capacitors, resistance, etc. may be interconnected. In some embodiments, a middle-of-line (MOL) may be performed between the FEOL and the BEOL, and contacts may be formed on the individual elements. Then, the integrated circuit IC may be packaged in the semiconductor package and be used as parts of various applications.

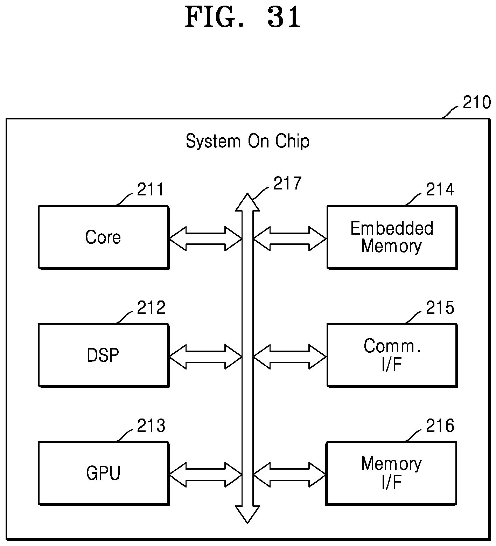

FIG. 31 is a block diagram of a system-on-chip (SoC) according to an embodiment.

Referring to FIG. 31, the SoC 210 may refer to an integrated circuit in which parts of a computing system or other electronic systems are integrated. For example, as an example of the SoC 210, an application processor (AP) may include parts for processors and other functions. The SoC 210 may include a core 211, a digital signal processor (DSP) 212, a graphic processing unit (GPU) 213, an embedded memory 214, a communication interface 215, and a memory interface 216. The components of the SoC 210 may communicate with each other through a bus 217.

The core 211 may process instructions and control the operation of the components included in the SoC 210. For example, the core 211 may process a series of instructions to run an operating system and execute applications on the operating system. The DSP 212 may generate useful data by processing a digital signal provided from an interface, such as a communication interface 215. The GPU 213 may generate data for images output through a display device from image data provided from the embedded memory 214 or the memory interface 216, or may encode image data. In some embodiments, the integrated circuit described above with reference to the drawings may be included in the core 211, the DSP 212, the GPU 213, and/or the embedded memory 214.

The embedded memory 214 may store the data necessary for operating the core 211, the DSP 212, and the GPU 213. The communication interface 215 may provide an interface for a communication network or one-to-one communication. The memory interface 216 may provide an interface for an external memory of the SoC 210, such as a dynamic random access memory (DRAM), a flash memory, and the like.

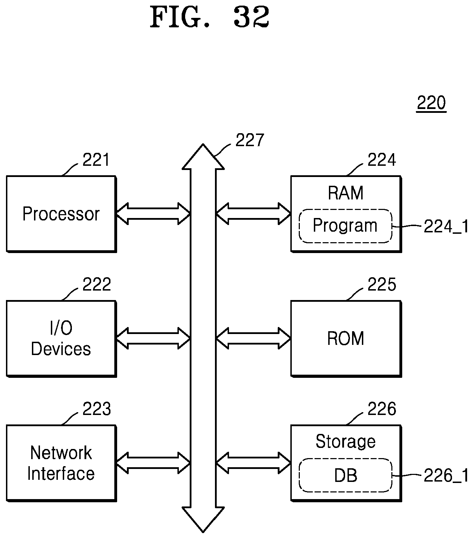

FIG. 32 is a block diagram showing a computing system 220 including a memory storing a program, according to an embodiment.

Referring to FIG. 32, at least some of the steps of designing an integrated circuit according to an embodiment, for example, at least some of the steps described in the flowchart, may be performed in the computing system (or a computer) 220. The computing system 220 may be a fixed computing system such as a desktop computer, a workstation, a server, etc., or a portable computing system such as a laptop computer. The computing system 220 may include a processor 221, input/output (I/O) devices 222, a network interface 223, a random access memory (RAM) 224, a read only memory (ROM) 225, and storage device 226. The processor 221, the input/output devices 222, the network interface 223, the RAM 224, the ROM 225, and storage device 226 may be connected to a bus 227, and may communicate with each other through the bus 227.

The processor 221 may be referred to as a processing unit, and may include at least one core, such as a micro-processor, an AP, a DSP, and a GPU, which may execute an instruction set (e.g., IA-32 (Intel Architecture-32), 64-bit expansion IA-32, x86-64, PowerPC, Sparc, MIPS, ARM, IA-64, etc.). For example, the processor 221 may access the memory, that is, the RAM 224 or the ROM 225, through the bus 227, and may execute instructions stored in the RAM 224 or the ROM 225.

The RAM 224 may store a program 224_1 or at least a portion of the program 224_1 for a method for designing the integrated circuit according to an embodiment, and the program 224_1 may control the processor 221 to execute the method for designing the integrated circuit, for example, at least some of the steps included in the methods of FIG. 30. That is, the program 224_1 may include a plurality of instructions that may be executed by the processor 221, and the plurality of instructions included in the program 224_1 may control the processor 221 to execute at least some of the steps included in the above-mentioned flowcharts.

The storage device 226 may not lose stored data even if the power applied to the computing system 220 is blocked. For example, the storage device 226 may include a nonvolatile memory device or may include a storage medium such as a magnetic tape, an optical disc, and a magnetic disk. In addition, the storage device 226 may be attachable to/detachable from the computing system 220. The storage device 226 may store the program 224_1 according to an embodiment, and the program 224_1 or at least a portion of the program 224_1 may be loaded from the storage device 226 to the RAM 224 before the program 224_1 is executed by the processor 221. In other words, the storage device 226 may store files written in program languages, and the program 224_1 or a portion of the program 224_1 generated by a compiler from the files may be loaded on the RAM 224. In addition, the storage device 226 may store database (DB) 226_1, and the database 226_1 may include information for designing the integrated circuit, for example, information regarding designed blocks, the cell library D12, and/or the design rules D14.

The storage device 226 may store data to be processed by the processor 221 or data processed by the processor 221. That is, the processor 221 may generate data by processing data stored in the storage device 226 according to the program 224_1, and may store the generated data in the storage device 226. For example, the storage device 226 may store the RTL data D11, the netlist data D13, and/or the layout data D15 of FIG. 30.

The input/output devices 222 may include an input device such as a keyboard, a pointing device, and the like, and may include an output device such as a display device and a printer. For example, a user may trigger the execution of the program 224_1 by the processor 221 through the input/output devices 222, may input the RTL data D11 and/or the netlist data D13 of FIG. 30, and may check the layout data D15 of FIG. 30. The network interface 223 may provide access to a network outside the computing system 220. For example, the network may include a plurality of computing systems and communication links, and the communication links may include wired links, optical links, wireless links or any other forms of links.

As described above, example embodiments are disclosed in the drawings and the specification. Although the embodiments were described using certain terms herein, the descriptions regarding the embodiments should be considered in an illustrative sense only, and do not limit the meaning or scope of the inventive concept as set forth in the claims. Therefore, those of ordinary skill in the art may understand that various modifications and equivalent embodiments may be possible. Therefore, the scope of the inventive concept should be defined by the inventive concept of the appended claims.

While the inventive concept has been particularly shown and described with reference to embodiments thereof, it will be understood that various changes in form and details may be made therein without departing from the scope of the following claims.

## Claims

1. An integrated circuit comprising:
a plurality of gate electrodes including a first gate electrode and a second gate electrode being apart in a first direction, and a third gate electrode and a fourth gate electrode being apart in the first direction, wherein the second gate electrode and the third gate electrode are configured to receive a first control signal, and the first gate electrode and the fourth gate electrode are configured receive a second control signal;
a plurality of drain regions comprising a first drain region between the first gate electrode and the second gate electrode, and a second drain region between the third gate electrode and the fourth gate electrode, wherein the first drain region and the second drain region are configured to be electrically connected to each other;
a front-side wiring layer disposed above the plurality of gate electrodes in a vertical direction and connected to at least one of the plurality of drain regions and the plurality of gate electrodes; and
a backside wiring layer disposed under the plurality of gate electrodes in the vertical direction and connected to at least another one of the plurality of drain regions and the plurality of gate electrodes.

2. The integrated circuit of claim 1, further comprising a first active region and a second active region, each of which extends in the first direction and is apart in a second direction perpendicular to the first direction, wherein
each of the first gate electrode and the second gate electrode extends in the second direction above the first active region, and
each of the third gate electrode and the fourth gate electrode extends in the second direction above the second active region.

3. The integrated circuit of claim 1 or 2, further comprising a backside contact connected to the first drain region and the second drain region and extending in a second direction perpendicular to the first direction, wherein
the first drain region and the second drain region are connected to the backside wiring layer through the backside contact.

4. The integrated circuit of claim 3, further comprising contacts respectively disposed on the plurality of gate electrodes, wherein
the front-side wiring layer comprises front-side wiring patterns respectively disposed on the contacts, and
at least one of the plurality of gate electrodes is connected to a corresponding front-side wiring pattern through a corresponding one of the contacts.

5. The integrated circuit of claim 3, further comprising a first contact disposed on the first gate electrode, a second contact disposed on the second gate electrode, a third contact disposed on the third gate electrode, and a fourth contact disposed on the fourth gate electrode, wherein
the front-side wiring layer includes a first front-side wiring pattern disposed on the first contact, a second front-side wiring pattern disposed on the second contact, a third front-side wiring pattern disposed on the third contact, and a fourth front-side wiring pattern disposed on the fourth contact, and
the first gate electrode is connected to the first front-side wiring pattern through the first contact, the second gate electrode is connected to the second front-side wiring pattern through the second contact, the third gate electrode is connected to the third front-side wiring pattern through the third contact, and the fourth gate electrode is connected to the fourth front-side wiring pattern through the fourth contact.

6. The integrated circuit of claim 1 or 2, further comprising a first contact connected to the first drain region and the second drain region and extending in a second direction perpendicular to the first direction, wherein
the first drain region and the second drain region are connected to the front-side wiring layer through the first contact.

7. The integrated circuit of claim 6, further comprising:
second contacts respectively disposed on the second gate electrode and the third gate electrode; and
backside contacts respectively connected to the first gate electrode and the fourth gate electrode, wherein
the second gate electrode and the third gate electrode are connected to the front-side wiring layer through the second contacts, and
the first gate electrode and the fourth gate electrode are connected to the backside wiring layer through the backside contacts.

8. The integrated circuit of claim 1 or 2, further comprising:
a first diagonal contact disposed on the first gate electrode and the fourth gate electrode to be connected to the first gate electrode and the fourth gate electrode;
a second diagonal contact disposed on the second gate electrode and the third gate electrode to be connected to the second gate electrode and the third gate electrode, wherein
the first gate electrode and the fourth gate electrode are connected to the front-side wiring layer through the first diagonal contact, and
the second gate electrode and the third gate electrode are connected to the backside wiring layer through the second diagonal contact.

9. The integrated circuit of claim 8, further comprising first contacts respectively disposed on the first drain region and the second drain region, wherein
the first drain region and the second drain region are connected to the front-side wiring layer through the first contacts.

10. The integrated circuit of claim 8, further comprising backside contacts respectively connected to the first drain region and the second drain region, wherein
the first drain region and the second drain region are connected to the backside wiring layer through the backside contacts.

11. An integrated circuit comprising:
a source region and a drain region being apart in a first direction;
a first gate electrode extending in a second direction perpendicular to the first direction, between the source region and the drain region;
first backside contacts disposed under the source region and the drain region in a vertical direction and respectively connected to the source region and the drain region; and
a backside wiring layer connected to the first backside contacts, wherein
the source region and the drain region are configured to receive a same voltage from the backside wiring layer through the first backside contacts.

12. The integrated circuit of claim 11, wherein the backside wiring layer extends in the first direction.

13. The integrated circuit of claim 11 or 12, further comprising backside vias respectively connected to the first backside contacts, wherein
the source region and the drain region are configured to receive the same voltage from the backside wiring layer through the first backside contacts and the backside vias.

14. The integrated circuit of any one of claims 11 to 13, further comprising a second backside contact disposed under the first gate electrode in the vertical direction and connected to the first gate electrode.

15. The integrated circuit of claim 14, wherein the second backside contact is electrically connected to at least one of the first backside contacts.
